# EUROPEAN PATENT APPLICATION

(11) **EP 4 239 664 A2**
(43) Date of publication of application: **06.09.2023**
(21) Application number: 22208971.6
(22) Date of filing: 23.11.2022
(51) Int. Cl.: H01L 21/8234, H01L 27/088, H01L 29/775, H01L 29/08

(54) **SEMICONDUCTOR DEVICE**

(30) Priority: 02.03.2022 KR 20220026615
(71) Applicant: Samsung Electronics Co., Ltd., Gyeonggi-do 16677 (KR)
(72) Inventor: YOU, Jung Gun, 16677 Suwon-si, Gyeonggi-do (KR); SUNG, Sug Hyun, 16677 Suwon-si, Gyeonggi-do (KR); HAN, Dong Woo, 16677 Suwon-si, Gyeonggi-do (KR)
(74) Representative: Kuhnen & Wacker Patent- und Rechtsanwaltsbüro PartG mbB

(57) **Abstract**

A semiconductor device comprising a first active pattern including a first lower pattern, and a plurality of first sheet patterns, a plurality of first gate structures on the first lower pattern, a second active pattern (AP2) including a second lower pattern (BP2) and a plurality of second sheet patterns (NS2), a plurality of second gate structures (GS2) on the second lower pattern, a first source/drain recess between adjacent first gate structures, a second source/drain recess (250R) between adjacent second gate structures, first and second source/drain patterns (250) in the first and second source/drain recesses, respectively, wherein a depth from an upper surface of the first lower pattern to a lowermost part of the first source/drain pattern is smaller than a depth (H21) from an upper surface (BP2_US) of the second lower pattern to a lowermost part of the second source/drain pattern, and the first and second source/drain patterns include impurities of same conductive type.

## Description

### CROSS-REFERENCE TO RELATED APPLICATION

This application claims priority from Korean Patent Application No. 10-2022-0026615, filed on March 2, 2022, in the Korean Intellectual Property Office, and all the benefits accruing therefrom, the entire contents of which are herein incorporated by reference.

### BACKGROUND

### 1. Field of the Invention

The present invention relates to a semiconductor device, and more specifically, to a semiconductor device including an MBCFET^{™} (Multi-Bridge Channel Field Effect Transistor).

### 2. Description of the Related Art

As one of scaling techniques for increasing the density of semiconductor devices, a multi gate transistor in which a fin or nanowire-shaped multi channel active pattern (or silicon body) is formed on a substrate and a gate is formed on a surface of the multi channel active pattern has been proposed.

Since such a multi gate transistor utilizes a three-dimensional channel, scaling is easily performed. Further, current control capability may be improved even without increasing a gate length of the multi gate transistor. Furthermore, a SCE (short channel effect) in which the potential of channel region is affected by a drain voltage may be effectively suppressed.

### SUMMARY

Aspects of the present invention provide a semiconductor device capable of improving an element performance and reliability.

However, aspects of the present invention are not restricted to those set forth herein. The above and other aspects of the present invention will become more apparent to one of ordinary skill in the art to which the present invention pertains by referencing the detailed description of the present invention given below.

According to an aspect of the present disclosure, there is provided a semiconductor device comprising a first active pattern which includes a first lower pattern extending lengthwise in a first direction, and a plurality of first sheet patterns spaced apart from the first lower pattern in a second direction, a plurality of first gate structures which are spaced apart in the first direction on the first lower pattern, each of the plurality of first gate structures including a first gate electrode and a first gate insulating film, the first gate electrodes adjacent to each other in the first direction being spaced apart by a first distance, a second active pattern which includes a second lower pattern extending lengthwise in the first direction, and a plurality of second sheet patterns spaced apart from the second lower pattern in the second direction, a plurality of second gate structures which are spaced apart in the first direction on the second lower pattern, each of the plurality of second gate structures including a second gate electrode and a second gate insulating film, the second gate electrodes adjacent to each other in the first direction being spaced apart by a second distance greater than the first distance, a first source/drain recess defined between the adjacent first gate structures, a second source/drain recess defined between the adjacent second gate structures, a first source/drain pattern disposed in the first source/drain recess; and a second source/drain pattern disposed in the second source/drain recess, wherein a depth from an upper surface of the first lower pattern to a lowermost part of the first source/drain pattern is smaller than a depth from an upper surface of the second lower pattern to a lowermost part of the second source/drain pattern, and wherein the first source/drain pattern and the second source/drain pattern include impurities of same conductive type.

According to another aspect of the present disclosure, there is provided a semiconductor device comprising, a first active pattern which includes a first lower pattern extending lengthwise in a first direction, and a plurality of first sheet patterns spaced apart from the first lower pattern in a second direction, a plurality of first gate structures which are spaced apart in the first direction on the first lower pattern, each of the plurality of first gate structures including a first gate electrode and a first gate insulating film, the first gate electrodes adjacent to each other in the first direction being spaced apart by a first distance, a second active pattern which includes a second lower pattern extending lengthwise in the first direction, and a plurality of second sheet patterns spaced apart from the second lower pattern in the second direction, a plurality of second gate structures which are spaced apart in the first direction on the second lower pattern, each of the plurality of second gate structures including a second gate electrode and a second gate insulating film, the second gate electrodes adjacent to each other in the first direction being spaced apart by a second distance greater than the first distance, a first source/drain recess defined between the adjacent first gate structures, a second source/drain recess defined between the adjacent second gate structures, a first source/drain pattern disposed in the first source/drain recess and a second source/drain pattern disposed in the second source/drain recess, wherein a height from an upper surface of the first lower pattern to a lowermost part of an upper surface of the first source/drain pattern is greater than a depth height from an upper surface of the second lower pattern to a lowermost part of an upper surface of the second source/drain pattern, and wherein the first source/drain pattern and the second source/drain pattern each include n-type impurities.

According to still another aspect of the present disclosure, there is provided a semiconductor device comprising, a first active pattern which includes a first lower pattern extending lengthwise in a first direction, and a plurality of first sheet patterns spaced apart from the first lower pattern in a second direction, a plurality of first gate structures which are spaced apart in the first direction on the first lower pattern, each of the plurality of first gate structures including a first gate electrode and a first gate insulating film, the first gate electrodes adjacent to each other in the first direction being spaced apart by a first distance, a second active pattern which includes a second lower pattern extending lengthwise in the first direction, and a plurality of second sheet patterns spaced apart from the second lower pattern in the second direction, a plurality of second gate structures which are spaced apart in the first direction on the second lower pattern, each of the plurality of second gate structures including a second gate electrode and a second gate insulating film, the second gate electrodes adjacent to each other in the first direction being spaced apart by a second distance greater than the first distance, a first source/drain recess defined between the adjacent first gate structures, a second source/drain recess defined between the adjacent second gate structures, a first source/drain pattern disposed in the first source/drain recess; and a second source/drain pattern disposed in the second source/drain recess, wherein a height from a lowermost part of an upper surface of the first source/drain pattern to an uppermost part of an upper surface of the first source/drain pattern is a first height, and wherein a height from a lowermost part of an upper surface of the second source/drain pattern to an uppermost part of an upper surface of the second source/drain pattern is a second height greater than the first height.

### BRIEF DESCRIPTION OF THE DRAWINGS

The above and other aspects and features of the present disclosure will become more apparent by describing in detail exemplary embodiments thereof with reference to the attached drawings, in which:
FIG. 1 is an exemplary layout diagram for explaining a semiconductor device, according to some example embodiments.
FIG. 2 is a cross-sectional view taken along a line A-A of FIG. 1.
FIG. 3 is a cross-sectional view taken along a line B-B of FIG. 1.
FIG. 4 is a cross-sectional view taken along a line C-C of FIG. 1.
FIGS. 5 and 6 are diagrams for explaining a semiconductor device, according to some example embodiments.
FIG. 7 is a diagram for explaining a semiconductor device, according to some example embodiments.
FIG. 8 is a diagram for explaining a semiconductor device, according to some example embodiments.
FIGS. 9 to 12 are diagrams for explaining a semiconductor device, according to some example embodiments, respectively.
FIG. 13 is an exemplary layout diagram for explaining a semiconductor device, according to some example embodiments.
FIG. 14 is a cross-sectional view taken along a line D-D of FIG. 13.
FIG. 15 is a cross-sectional view taken along a line E-E of FIG. 13.
FIG. 16 is a diagram for explaining a semiconductor device, according to some example embodiments.

### DETAILED DESCRIPTION OF THE EMBODIMENTS

A semiconductor device according to some example embodiments may include a tunneling field effect transistor (tunneling FET), a three-dimensional (3D) transistor, a field effect transistor based on a two-dimensional material (2D material based FETs), and a heterostructure thereof. Further, the semiconductor device according to some example embodiments may also include a bipolar junction transistor, a laterally diffused metal oxide semiconductor (LDMOS), or the like.

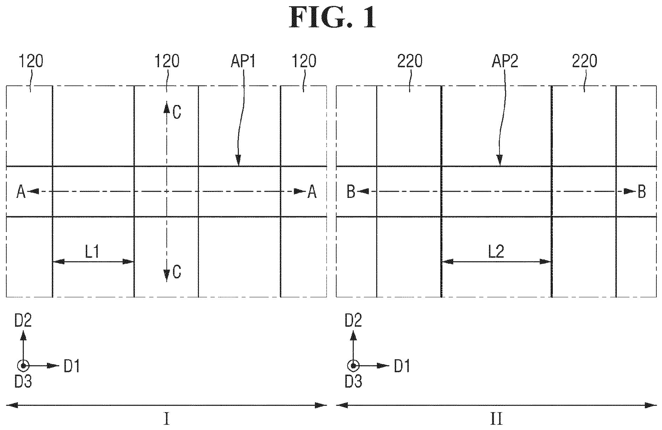

The semiconductor device according to some example embodiments will be described referring to FIGS. 1 to 4.

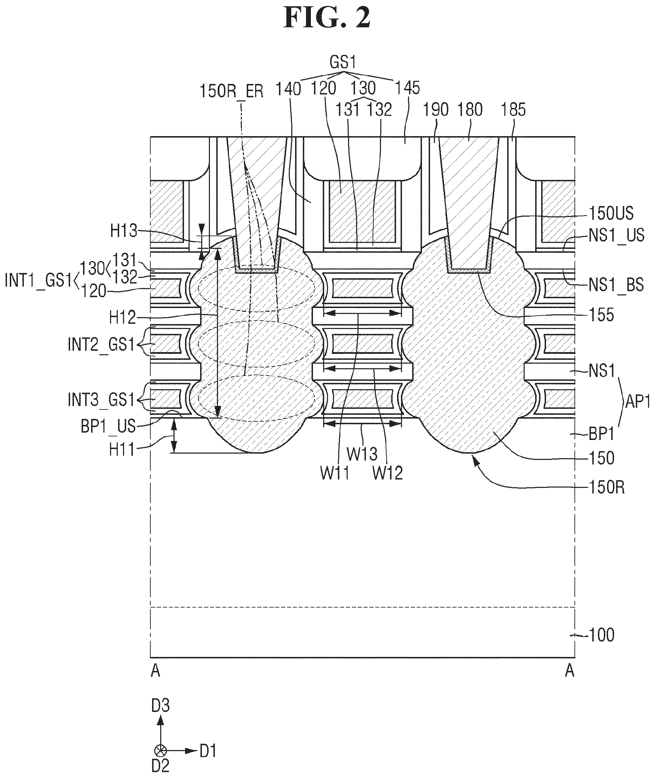

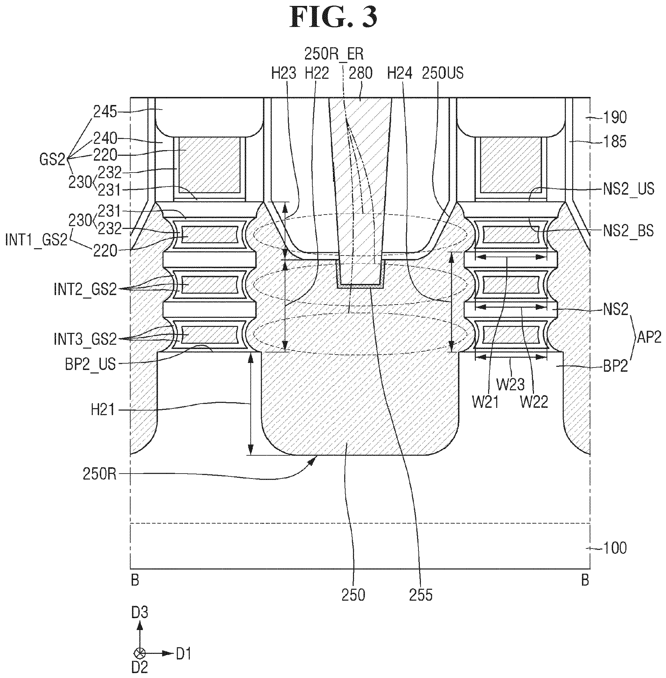

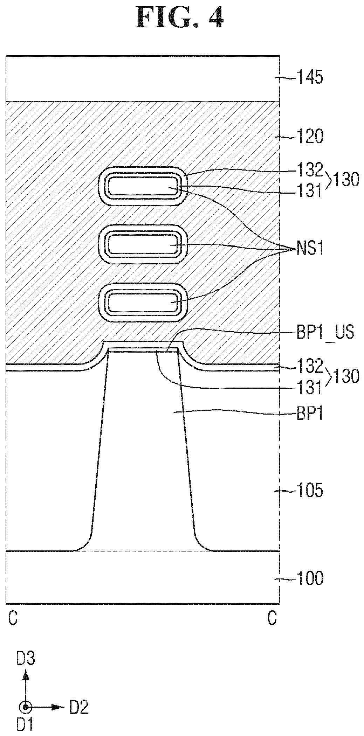

FIG. 1 is an exemplary layout diagram for explaining the semiconductor device according to some example embodiments. FIG. 2 is a cross-sectional view taken along a line A-A of FIG. 1. FIG. 3 is a cross-sectional view taken along a line B-B of FIG. 1. FIG. 4 is a cross-sectional view taken along a line C-C of FIG. 1.

For reference, although not shown in FIG. 1, a cross-sectional view taken along a second gate electrode 220 in a second direction D2 may be the same as that of FIG. 4.

Referring to FIGS. 1 to 4, the semiconductor device according to some example embodiments may include a first active pattern AP1, a plurality of first gate electrodes 120, a first source/drain pattern 150, a second active pattern AP2, a plurality of second gate electrodes 220, and a second source/drain pattern 250.

The substrate 100 may include a first region I and a second region II. As an example, the first region I and the second region II may be regions that are adjacent to each other. For example, one of the second gate electrodes 220 of the second region II may be the first gate electrode 120 of the first region I. As another example, the first region I and the second region II may be regions that are separated from each other.

The substrate 100 may include the first region I and the second region II. The first region I and the second region II may be one of a logic region, a static random access memory (SRAM) region, and an input/output (I/O) region, respectively. As an example, the first region I and the second region II may be regions that perform the same function as each other. As another example, the first region I and the second region II may be regions that perform different functions from each other.

The first region I and the second region II may be regions in which the transistor of the same conductive type is formed. For example, the first region I and the second region II may be regions in which an n-type metal oxide semiconductor (NMOS) is formed.

The substrate 100 may be a bulk silicon or a SOI (silicon-on-insulator). In contrast, the substrate 100 may be a silicon substrate, or may include, but is not limited to, other materials, for example, silicon germanium, SGOI (silicon germanium on insulator), indium antimonide, lead tellurium compounds, indium arsenic, indium phosphate, gallium arsenide or antimonide gallium.

The first active pattern AP1, the plurality of first gate electrodes 120, and the first source/drain pattern 150 are disposed in the first region I of the substrate 100. The second active pattern AP2, the plurality of second gate electrodes 220, and the second source/drain pattern 250 are disposed in the second region II of the substrate 100.

The first active pattern AP1 and the second active pattern AP2 may be disposed on the substrate 100, respectively. The first active pattern AP1 and the second active pattern AP2 may each extend lengthwise in the first direction D1.

Unlike the illustrated example, one of the first active pattern AP1 and the second active pattern AP2 may extend lengthwise in the first direction D1, and the other thereof may extend lengthwise in the second direction D2. In the following description, the first active pattern AP1 and the second active pattern AP2 will be described to extend lengthwise in the first direction D1.

Each of the first active pattern AP1 and the second active pattern AP2 may be a multi-channel active pattern. The first active pattern AP1 may include a first lower pattern BP1 and a plurality of first sheet patterns NS1. The second active pattern AP2 may include a second lower pattern BP2 and a plurality of second sheet patterns NS2.

The first lower pattern BP1 may protrude from the substrate 100. The first lower pattern BP1 may extend lengthwise in the first direction D1. The second lower pattern BP2 may protrude from the substrate 100. For example, an upper surface BP2_US of the second lower pattern BP2 may be at a higher level than an upper surface of the substrate 100. The second lower pattern BP2 may extend lengthwise in the first direction D1.

The plurality of first sheet patterns NS1 may be disposed on an upper surface BP1_US of the first lower pattern BP1. The plurality of first sheet patterns NS1 may be spaced apart from the first lower pattern BP1 in a third direction D3. Each first sheet pattern NS1 may be spaced apart from one another in the third direction D3.

The plurality of second sheet patterns NS2 may be disposed on an upper surface BP2_US of the second lower pattern BP2. The plurality of second sheet patterns NS2 may be spaced apart from the second lower pattern BP2 in the third direction D3. Each second sheet pattern NS2 may be spaced apart in the third direction D3.

Each first sheet pattern NS1 may include an upper surface NS1_US and a lower surface NS1_BS. The upper surface NS1_US of the first sheet pattern NS1 is a surface that is opposite to a lower surface NS1_BS of the first sheet pattern NS1 in the third direction D3. For example, the lower surface NS1_BS of the first sheet pattern NS1 may face the substrate 100, and the upper surface NS1_US of the first sheet pattern NS1 may face away from the substrate 100.

Each second sheet pattern NS2 may include an upper surface NS2_US and a lower surface NS2_BS. The upper surface NS2_US of the second sheet pattern NS2 is a surface that is opposite to a lower surface NS2_BS of the second sheet pattern NS2 in the third direction D3. For example, the lower surface NS2_BS of the second sheet pattern NS2 may face the substrate 100, and the upper surface NS2_US of the second sheet pattern NS2 may face away from the substrate 100. The third direction D3 may be a direction that intersects the first direction D1 and the second direction D2. For example, the third direction D3 may be a thickness direction of the substrate 100. The first direction D1 may be a direction that intersects the second direction D2.

Although each of the three first sheet patterns NS1 and the three second sheet pattern NS2 is shown to be disposed in the third direction D3, this is only for convenience of explanation, and the present invention is not limited thereto.

The first lower pattern BP1 and the second lower pattern BP2 may each be formed by etching a part of the substrate 100, and may include an epitaxial layer that is grown from the substrate 100. The first lower pattern BP1 and the second lower pattern BP2 may each include silicon or germanium, which are elemental semiconductor materials. Further, the first lower pattern BP1 and the second lower pattern BP2 may each include a compound semiconductor, and may include, for example, a group IV-IV compound semiconductor or a group III-V compound semiconductor.

The group IV-IV compound semiconductor may include, for example, a binary compound or a ternary compound including at least two or more of carbon (C), silicon (Si), germanium (Ge), and tin (Sn), or a compound obtained by doping these elements with a group IV element.

The group III-V compound semiconductor may be, for example, at least one of a binary compound, a ternary compound or a quaternary compound formed by combining at least one of aluminum (Al), gallium (Ga) and indium (In) as a group III element with one of phosphorus (P), arsenic (As) and antimony (Sb) as a group V element.

The first sheet pattern NS1 and the second sheet pattern NS2 may include one of silicon or germanium which is an elemental semiconductor material, a group IV-IV compound semiconductor, or a group III-V compound semiconductor. Each first sheet pattern NS1 may include the same material as the first lower pattern BP1, and may include a different material from the first lower pattern BP1. Each second sheet pattern NS2 may include the same material as the second lower pattern BP2, and may include a different material from the second lower pattern BP2.

In the semiconductor device according to some embodiments, the first lower pattern BP1 and the second lower pattern BP2 may each be silicon lower patterns including silicon, and the first sheet pattern NS1 and the second sheet pattern NS2 may each be a silicon sheet pattern including silicon.

A width of the first sheet pattern NS1 in the second direction D2 may increase or decrease in proportion to a width of the upper surface BP1_US of the first lower pattern in the second direction D2. A width of the second sheet pattern NS2 in the second direction D2 may increase or decrease in proportion to a width of the upper surface BP2_US of the second lower pattern in the second direction D2.

Although it is shown that the widths in the second direction D2 of the first sheet patterns NS1 stacked in the third direction D3 are the same, and the width in the second direction D2 of the first sheet patterns NS1 stacked in the third direction D3 are the same, this is only for convenience of explanation, and the embodiment is not limited thereto. Unlike the illustrated example, the widths in the second direction D2 of the first sheet patterns NS1 stacked in the third direction D3 may decrease, as it extends away from the first lower pattern BP1. Needless to say, the above description is also applicable to the second active pattern AP2.

Although FIG. 1 shows that the width of the first active pattern AP1 in the second direction D2 is the same as the width of the second active pattern AP2 in the second direction D2, the embodiment is not limited thereto. For reference, the width of the first active pattern AP1 in the second direction D2 may be a width of the upper surface BP1_US of the first lower pattern in the second direction D2.

A field insulating film 105 may be formed on the substrate 100. The field insulating film 105 may be disposed on the side walls of the first lower pattern BP1. The field insulating film 105 is not disposed on the upper surface BP1_US of the first lower pattern BP1.

As an example, the field insulating film 105 may completely cover the side walls of the first lower pattern BP1. Unlike the illustrated example, the field insulating film 105 may cover a part of the side walls of the first lower pattern BP1. In such a case, a part of the first lower pattern BP1 may protrude from the upper surface of the field insulating film 105 in the third direction D3.

Each first sheet pattern NS1 is disposed to be higher than the upper surface of the field insulating film 105. The above description may also be applied to a relationship between the field insulating film 105 and the second lower pattern BP2. For example, the field insulating film 105 may be disposed on the side walls of the second lower pattern BP2. The field insulating film 105 is not disposed on the upper surface BP2_US of the second lower pattern BP2. The field insulating film 105 may completely cover the side walls of the second lower pattern BP2. Alternatively, the field insulating film 105 may cover a part of the side walls of the second lower pattern BP2.

The field insulating film 105 may include, for example, an oxide film, a nitride film, an oxynitride film or a combination film thereof. Although the field insulating film 105 is shown as a single film, this is only for convenience of explanation, and the embodiment is not limited thereto.

A plurality of first gate structures GS1 may be disposed on the substrate 100. Each first gate structure GS1 may extend lengthwise in the second direction D2. The first gate structures GS1 may be disposed to be spaced apart from each other in the first direction D1. The first gate structures GS1 may be adjacent to each other in the first direction D1. For example, the first gate structure GS1 may be disposed on both sides of the first source/drain pattern 150 in the first direction D1.

The first gate structure GS1 may be disposed on the first active pattern AP1. The first gate structure GS1 may intersect the first active pattern AP1. The first gate structure GS1 may intersect the first lower pattern BP1. The first gate structure GS1 may wrap each first sheet pattern NS1. For example, the first gate structure GS1 may surround each first sheet pattern NS 1.

The first gate structure GS1 may include, for example, a first gate electrode 120, a first gate insulating film 130, a first gate spacer 140, and a first gate capping pattern 145.

The first gate structure GS1 may include a plurality of inner gate structures INT1_GS1, INT2_GS1, and INT3_GS1 that are disposed between the first sheet patterns NS1 adjacent to each other in the third direction D3, and between the first lower pattern BP1 and the first sheet pattern NS1. The inner gate structures INT1_GS1, INT2_GS1, and INT3_GS1 may be disposed between the upper surface BP1_US of the first lower pattern and the lower surface NS1_BS of the first lowermost sheet pattern, and between the upper surface NS1_US of the first sheet pattern and the lower surface NS1_BS of the first sheet pattern facing each other in the third direction D3.

The number of inner gate structures INT1_GS1, INT2_GS1, and INT3_GS1 may be proportional to the number of first sheet patterns NS1 included in the active pattern AP1. For example, the number of inner gate structures INT1_GS1, INT2_GS1, and INT3_GS1 may be the same as the number of the first sheet patterns NS1. Since the first active pattern AP1 includes a plurality of first sheet patterns NS1, the first gate structure GS1 may include a plurality of inner gate structures.

The inner gate structures INT1_GS1, INT2_GS1, and INT3_GS1 may contact the upper surface BP1_US of the first lower pattern BP1, the upper surface NS1_US of the first sheet pattern NS1, and the lower surface NS1_BS of the first sheet pattern NS1. As used herein, the term "contact" refers to a direct connection (i.e., touching) unless the context indicates otherwise.

The inner gate structures INT1_GS1, INT2_GS1, and INT3_GS1 may contact a first source/drain pattern 150 to be described later. For example, the inner gate structures INT1_GS1, INT2_GS1, and INT3_GS1 may come into direct contact with the first source/drain pattern 150.

The following description will be provided, using a case where the number of the inner gate structures INT1_GS1, INT2_GS1, and INT3_GS1 is three.

The first gate structure GS1 may include a first inner gate structure INT1_GS1, a second inner gate structure INT2_GS1, and a third inner gate structure INT3_GS1. The first inner gate structure INT1_GS1, the second inner gate structure INT2_GS1, and the third inner gate structure INT3_GS1 may be sequentially disposed on the first lower pattern BP1.

The third inner gate structure INT3_GS1 may be disposed between the first lower pattern BP1 and the first sheet pattern NS1. The third inner gate structure INT3_GS1 may be disposed at the lowermost part among the inner gate structures INT1_GS1, INT2_GS1, and INT3_GS1. The third inner gate structure INT3_GS1 may be the lowermost inner gate structure. The third inner gate structure INT3_GS1 may contact the upper surface BP1_US of the first lower pattern BP1.

The first inner gate structure INT1_GS1 and the second inner gate structure INT2_GS1 may be disposed between the first sheet patterns NS1 adjacent to each other in the third direction D3. The first inner gate structure INT1_GS1 may be disposed at the uppermost part among the inner gate structures INT1_GS1, INT2_GS1, and INT3_GS1. The first inner gate structure INT1_GS1 may be the uppermost inner gate structure. The first inner gate structure INT1_GS1 may contact the lower surface NS1_BS of the first sheet pattern disposed at the uppermost part. The second inner gate structure INT2_GS1 is disposed between the first inner gate structure INT1_GS1 and the third inner gate structure INT3_GS1.

The inner gate structures INT1_GS1, INT2_GS1, and INT3_GS1 include a first gate electrode 120 and a first gate insulating film 130 that are disposed between the adjacent first sheet patterns NS1, and between the first lower pattern BP1 and the first sheet pattern NS1.

For example, a width W11 of the first inner gate structure INT1_GS1 in the first direction D1 may be the same as a width W12 of the second inner gate structure INT2_GS1 in the first direction D1. In the semiconductor device according to some embodiments, a width W13 of the third inner gate structure INT3_GS1 in the first direction D1 may be the same as a width W12 of the second inner gate structure INT2_GS1 in the first direction D1.

The second inner gate structure INT2_GS1 will be described as an example. The width W12 of the second inner gate structure INT2_GS1 may be measured in the middle between the upper surface NS1_US of the first sheet pattern NS1 and the lower surface NS1_BS of the first sheet pattern NS1 facing each other in the third direction D3.

A plurality of second gate structures GS2 may be disposed on the substrate 100. Each second gate structure GS2 may extend lengthwise in the second direction D2. The second gate structures GS2 may be disposed apart from each other in the first direction D1. The second gate structures GS2 may be adjacent to each other in the first direction D1. For example, the second gate structures GS2 may be disposed on both sides of the second source/drain pattern 250 in the first direction D1.

The second gate structure GS2 may be disposed on the second active pattern AP2. The second gate structure GS2 may intersect the second active pattern AP2. The second gate structure GS2 may intersect the second lower pattern BP2. Although not shown, the second gate structure GS2 may wrap each second sheet pattern NS2. For example, the second gate structure GS2 may surround each second sheet pattern NS2.

The second gate structure GS2 may include, for example, a second gate electrode 220, a second gate insulating film 230, a second gate spacer 240, and a second gate capping pattern 245.

The second gate structure GS2 may include a plurality of inner gate structures INT1_GS2, INT2_GS2, and INT3_GS2 that are disposed between the second sheet patterns NS2 adjacent to each other in the third direction D3, and between the second lower pattern BP2 and the second sheet pattern NS2. The inner gate structures INT1_GS2, INT2_GS2, and INT3_GS2 may contact the upper surface BP2_US of the second lower pattern BP2, the upper surface NS2_US of the second sheet pattern NS2, and the lower surface NS2_BS of the second sheet pattern NS2. The inner gate structures INT1_GS2, INT2_GS2, and INT3_GS2 may contact a second source/drain pattern 250 to be described later.

The second gate structure GS2 may include a fourth inner gate structure INT1_GS2, a fifth inner gate structure INT2_GS2, and a sixth inner gate structure INT3_GS2. The sixth inner gate structure INT3_GS2 may be disposed between the second lower pattern BP2 and the second sheet pattern NS2. The sixth inner gate structure INT3_GS2 may be the lowermost inner gate structure. The fourth inner gate structure INT1_GS2 may be disposed at the uppermost part among the inner gate structures INT1_GS2, INT2_GS2, and INT3_GS2. The fourth inner gate structure INT1_GS2 may be the uppermost inner gate structure. The fifth inner gate structure INT2_GS2 is disposed between the fourth inner gate structure INT1_GS2 and the sixth inner gate structure INT3_GS2.

The inner gate structures INT1_GS2, INT2_GS2, and INT3_GS2 include a second gate electrode 220 and a second gate insulating film 230 that are disposed between the adjacent second sheet patterns NS2, and between the second lower pattern BP2 and the second sheet pattern NS2.

For example, a width W21 of the fourth inner gate structure INT1_GS2 in the first direction D1 may be the same as a width W22 of the fifth inner gate structure INT2_GS2 in the first direction D1. A width W23 of the sixth inner gate structure INT3_GS2 in the first direction D1 may be the same as the width W22 of the fifth inner gate structure INT2_GS2 in the first direction D1.

When the first active pattern AP1 and the second active pattern AP2 extend in different directions from each other, the direction in which the second gate structure GS2 extends is different from the direction in which the first gate structure GS1 extends.

The first gate electrode 120 may be disposed on the first lower pattern BP1. The first gate electrode 120 may intersect the first lower pattern BP1. The first gate electrode 120 may wrap the first sheet pattern NS1. A part of the first gate electrode 120 may be disposed between the adjacent first sheet patterns NS1, and between the first lower pattern BP1 and the first sheet pattern NS1.

The second gate electrode 220 may be disposed on the second lower pattern BP2. The second gate electrode 220 may intersect the second lower pattern BP2. A part of the second gate electrode 220 may be disposed between the adjacent second sheet patterns NS2, and between the second lower pattern BP2 and the second sheet pattern NS2. Although not shown, the second gate electrode 220 may wrap the second sheet pattern NS2.

The first gate electrodes 120 adjacent to each other in the first direction D1 may be spaced apart by a first distance L1. The second gate electrodes 220 adjacent to each other in the first direction D1 may be spaced apart by a second distance L2. The distance L2 by which the second gate electrodes 220 are spaced apart is larger than the distance L1 by which the first gate electrodes 120 are spaced apart.

For example, in the two first gate electrodes 120 disposed with the first source/drain pattern 150 interposed therebetween, the distance L1 by which the first gate electrodes 120 are spaced apart in the first direction D1 may be a distance between the side walls of the first gate electrode 120 facing each other in the first direction D1 with the first source/drain pattern 150 interposed therebetween.

The first gate electrode 120 and the second gate electrode 220 may each include at least one of a metal, a metal alloy, a conductive metal nitride, a metal silicide, a doped semiconductor material, a conductive metal oxide, and a conductive metal oxynitride. The first gate electrode 120 may include, for example, but is not limited to, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and combinations thereof. The conductive metal oxide and the conductive metal oxynitride may include, but are not limited to, an oxidized form of the above-mentioned materials.

The first gate electrode 120 may be disposed on both sides of a first source/drain pattern 150 to be described later. The first gate structure GS1 may be disposed on both sides of the first source/drain pattern 150 in the first direction D1.

As an example, both the first gate electrodes 120 disposed on both sides of the first source/drain pattern 150 may be normal gate electrodes that are used as gates of the transistor. As another example, the first gate electrode 120 disposed on one side of the first source/drain pattern 150 is used as a gate of the transistor, but the first gate electrode 120 disposed on the other side of the first source/drain pattern 150 may be a dummy gate electrode.

The second gate electrode 220 may be disposed on both sides of a second source/drain pattern 250 to be described later. The second gate structure GS2 may be disposed on both sides of the second source/drain pattern 250 in the first direction D1.

As an example, both the second gate electrodes 220 disposed on both sides of the second source/drain pattern 250 may be normal gate electrodes that are used as the gate of the transistor. As another example, the second gate electrode 220 disposed on one side of the second source/drain pattern 250 is used as the gate of the transistor, but the second gate electrode 220 disposed on the other side of the second source/drain pattern 250 may be a dummy gate electrode.

The first gate insulating film 130 may extend along the upper surface of the field insulating film 105 and the upper surface BP1_US of the first lower pattern BP1. The first gate insulating film 130 may wrap the first sheet pattern NS1. For example, the first gate insulating film 130 may surround the first sheet pattern NS1. The first gate insulating film 130 may be disposed along the periphery of the first sheet pattern NS1. The first gate electrode 120 is disposed on the first gate insulating film 130. The first gate insulating film 130 is disposed between the first gate electrode 120 and the first sheet pattern NS1.

A part of the first gate insulating film 130 may be disposed between the first sheet patterns NS1 adjacent to each other in the third direction D3, and between the first lower pattern BP1 and the first sheet pattern NS1. When the first sheet pattern NS1 includes a lower sheet pattern and an upper sheet pattern adjacent to each other in the third direction D3, a part of the first gate insulating film 130 may extend along the upper surface NS1_US of the lower sheet pattern and the lower surface NS1_BS of the upper sheet pattern that face each other.

The first gate insulating film 130 may include a first gate interface insulating film 131 and a first gate high dielectric constant insulating film 132. The first gate high dielectric constant insulating film 132 may be disposed between the first gate interface insulating film 131 and the first gate electrode 120.

The first gate interface insulating film 131 may extend along the upper surface BP1_US of the first lower pattern BP1. The first gate interface insulating film 131 may extend along the first source/drain pattern 150. The first gate interface insulating film 131 may be disposed along the periphery of the first sheet pattern NS1. The first gate interface insulating film 131 may come into direct contact with the first lower pattern BP1, the first source/drain pattern 150, and the first sheet pattern NS1.

The first gate interface insulating film 131 may not extend along the upper surface of the field insulating film 105. The first gate interface insulating film 131 may not extend along side walls of a first gate spacer 140, which will be described later. However, depending on the method of forming the first gate interface insulating film 131, the first gate interface insulating film 131 may extend along the upper surface of the field insulating film 105 and the side walls of the first gate spacer 140.

The first gate high dielectric constant insulating film 132 may extend along the upper surface of the field insulating film 105 and the upper surface BP1_US of the first lower pattern BP1. The first gate high dielectric constant insulating film 132 may extend along the first source/drain pattern 150. The first gate high dielectric constant insulating film 132 may be disposed along the periphery of the first sheet pattern NS1. The first gate high dielectric constant insulating film 132 may extend along the side walls of the first gate spacer 140 to be described later.

Since the description of the second gate insulating film 230 is the same as the description of the first gate insulating film 130, the second gate insulating film 230 will be briefly described.

The second gate electrode 220 is disposed on the second gate insulating film 230. The second gate insulating film 230 is disposed between the second gate electrode 220 and the second sheet pattern NS2.

The second gate insulating film 230 may include a second gate interface insulating film 231 and a second gate high dielectric constant insulating film 232. The second gate high dielectric constant insulating film 232 may be disposed between the second gate interface insulating film 231 and the second gate electrode 220.

The first gate interface insulating film 131 and the second gate interface insulating film 231 may include at least one of silicon oxide, silicon-germanium oxide, and germanium oxide. The first gate interface insulating film 131 and the second gate interface insulating film 231 may further include, but is not limited to, at least one of boron (B), phosphorus (P), carbon (C), arsenic (As), antimony (Sb), and bismuth (Bi).

The first gate high dielectric constant insulating film 132 and the second gate high dielectric constant insulating film 232 may include, for example, one or more of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate.

The semiconductor device according to some embodiments may include an NC (Negative Capacitance) FET that uses a negative capacitor. For example, the first gate high dielectric constant insulating film 132 and/or the second gate high dielectric constant insulating film 232 may include a ferroelectric material film having ferroelectric properties. As another example, the first gate high dielectric constant insulating film 132 and/or the second gate high dielectric constant insulating film 232 may include the ferroelectric material film having ferroelectric properties and a paraelectric material film having paraelectric properties.

The ferroelectric material film may have a negative capacitance, and the paraelectric material film may have a positive capacitance. For example, when two or more capacitors are connected in series and the capacitance of each capacitor has a positive value, the overall capacitances decrease from the capacitance of each of the individual capacitors. On the other hand, when at least one of the capacitances of two or more capacitors connected in series has a negative value, the overall capacitances may be greater than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. By the use of the increased overall capacitance value, a transistor including the ferroelectric material film may have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, and lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of dopant included in the ferroelectric material film may vary, depending on which type of ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have the paraelectric properties. The paraelectric material film may include at least one of, for example, a silicon oxide and a metal oxide having a high dielectric constant. The metal oxide included in the paraelectric material film may include, for example, but is not limited to, at least one of hafnium oxide, zirconium oxide, and aluminum oxide.

The ferroelectric material film and the paraelectric material film may include the same material. The ferroelectric material film has the ferroelectric properties, but the paraelectric material film may not have the ferroelectric properties. For example, when the ferroelectric material film and the paraelectric material film include hafnium oxide, a crystal structure of hafnium oxide included in the ferroelectric material film differs from a crystal structure of hafnium oxide included in the paraelectric material film.

The ferroelectric material film may have a thickness having the ferroelectric properties. A thickness of the ferroelectric material film may be, for example, but is not limited to, 0.5 to 10 nm. Since a critical thickness that exhibits the ferroelectric properties may vary for each ferroelectric material, the thickness of the ferroelectric material film may vary depending on the ferroelectric material.

As an example, the first gate high dielectric constant insulating film 132 and/or the second gate high dielectric constant insulating film 232 may include one ferroelectric material film. As another example, the first gate high dielectric constant insulating film 132 and/or the second gate high dielectric constant insulating film 232 may each include a plurality of ferroelectric material films spaced apart from each other. The first gate high dielectric constant insulating film 132 and/or the second gate high dielectric constant insulating film 232 may have a stacked film structure in which the plurality of ferroelectric material films and the plurality of paraelectric material films are alternately stacked.

The first gate spacer 140 may be disposed on the side walls of the first gate electrode 120. The first gate spacer 140 may not be disposed between the first lower pattern BP1 and the first sheet pattern NS1, and between the first sheet patterns NS1 adjacent to each other in the third direction D3.

The second gate spacer 240 may be disposed on the side wall of the second gate electrode 220. The second gate spacer 240 may not be disposed between the second lower pattern BP2 and the second sheet pattern NS2, and between the second sheet patterns NS1 adjacent to each other in the third direction D3. In the semiconductor device according to some embodiments, the first gate spacer 140 and the second gate spacer 240 may include only the outer spacer.

The first gate spacer 140 and the second gate spacer 240 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof. Although the first gate spacer 140 and the second gate spacer 240 are each shown as being a single layer, this is only for convenience of explanation, and the embodiment is not limited thereto.

The first gate capping pattern 145 may be disposed on the first gate electrode 120 and the first gate spacer 140. The second gate capping pattern 245 may be disposed on the second gate electrode 220 and the second gate spacer 240. The upper surface of the first gate capping pattern 145 and the upper surface of the second gate capping pattern 245 may be disposed on the same plane as the upper surface of the interlayer insulating film 190.

Unlike the illustrated example, the first gate capping pattern 145 may be disposed between the first gate spacers 140, and the second gate capping pattern 245 may be disposed between the second gate spacers 240.

The first gate capping pattern 145 and the second gate capping pattern 245 may each include, for example, at least one of silicon nitride (SiN), silicon oxynitride (SiON), silicon carbonitride (SiCN), silicon oxycarbonitride (SiOCN), and combinations thereof. The first gate capping pattern 145 and the second gate capping pattern 245 may include a material having an etching selectivity with respect to the interlayer insulating film 190.

The first source/drain pattern 150 may be disposed on the first active pattern AP1. The first source/drain pattern 150 may be disposed on the first lower pattern BP1. The first source/drain pattern 150 may be connected to the first sheet pattern NS1. The first source/drain pattern 150 may contact the first sheet pattern NS1.

The first source/drain pattern 150 may be disposed on the side surface of the first gate structure GS1. The first source/drain pattern 150 may be disposed between the first gate structures GS1 adjacent to each other in the first direction D1. For example, the first source/drain pattern 150 may be disposed on both sides of the first gate structure GS1. Unlike the illustrated example, the first source/drain pattern 150 may be disposed on one side of the first gate structure GS1, but may not be disposed on the other side of the first gate structure GS1.

The second source/drain pattern 250 may be disposed on the second active pattern AP2. The second source/drain pattern 250 may be disposed on the second lower pattern BP2. The second source/drain pattern 250 is connected to the second sheet pattern NS2. The second source/drain pattern 250 may contact the second sheet pattern NS2.

The second source/drain pattern 250 may be disposed on the side surface of the second gate structure GS2. The second source/drain pattern 250 may be disposed between the second gate structures GS2 adjacent to each other in the first direction D1. For example, the second source/drain pattern 250 may be disposed on both sides of the second gate structure GS2. Unlike the illustrated example, the second source/drain pattern 250 may be disposed on one side of the second gate structure GS2, but may not be disposed on the other side of the second gate structure GS2.

The first source/drain pattern 150 and the second source/drain pattern 250 may be included in the source/drain of the transistor that uses the first sheet pattern NS1 and the second sheet pattern NS2 as the channel region.

The first source/drain pattern 150 may be disposed in a first source/drain recess 150R. The second source/drain pattern 250 may be disposed in a second source/drain recess 250R. The first source/drain recess 150R and the second source/drain recess 250R each extend in the third direction D3. The first source/drain recess 150R may be defined between the first gate structures GS1 adjacent to each other in the first direction D1. The second source/drain recess 250R may be defined between the second gate structures GS2 adjacent to each other in the second direction D2. For example, the first source/drain recess 150R and the second source/drain recess 250R may be formed by the same fabricating process, but are not limited thereto.

A bottom surface of the first source/drain recess 150R may be defined by the first lower pattern BP1. A bottom surface of the second source/drain recess 250R may be defined by the second lower pattern BP2.

In the semiconductor device according to some embodiments, the side walls of the first source/drain recess 150R may be defined by the first sheet pattern NS1 and the inner gate structures INT1_GS1, INT2_GS1, and INT3_GS1. The side walls of the second source/drain recess 250R may be defined by the second sheet pattern NS2 and the inner gate structures INT1_GS2, INT2_GS2, and INT3_GS2. Taking the first gate structure GS1 as an example, the inner gate structures INT1_GS1, INT2_GS1, and INT3_GS1 may include upper surfaces that face the lower surface NS1_BS of the first sheet pattern NS1. The inner gate structures INT1_GS1, INT2_GS1, and INT3_GS1 include lower surfaces that face the upper surface NS1_US of the first sheet pattern or the upper surface BP1_US of the first lower pattern BP1. The inner gate structures INT1_GS1, INT2_GS1, and INT3_GS1 include side walls that connect the upper surfaces of the inner gate structures INT1_GS1, INT2_GS1, and INT3_GS1 and the lower surfaces of the inner gate structures INT1_GS1, INT2_GS1, and INT3_GS1. The side walls of the inner gate structure INT1_GS1, INT2_GS1, and INT3_GS1 may define a part of the side walls of the first source/drain recess 150R.

The upper surface BP1_US of the first lower pattern may be a boundary between a third inter-gate structure INT3_GS1 disposed at the lowermost part and the first lower pattern BP1. The bottom surface of the first source/drain recess 150R is lower than the upper surface BP1_US of the first lower pattern BP1. Similarly, the bottom surface of the second source/drain recess 250R is lower than the upper surface BP2_US of the second lower pattern BP2. For example, the upper surface BP1_US of the first lower pattern BP1 may be at a higher level in the third direction D3 than the bottom surface of the first source/drain recess 150R, and the upper surface BP2_US of the second lower pattern BP2 may be at a higher level in the third direction D3 than the bottom surface of the second source/drain recess 250R.

The side walls of the first source/drain recess 150R and the side walls of the second source/drain recess 250R may each have a wavy shape. The first source/drain recess 150R may include a plurality of first width expansion regions 150R_ER. Each first width expansion region 150R_ER may be defined above the upper surface BP1_US of the first lower pattern BP1. The second source/drain recess 250R may include a plurality of second width expansion regions 250R_ER. Each second width expansion region 250R_ER may be defined above the upper surface BP2_US of the second lower pattern BP2.

The first width expansion region 150R ER may be defined between the first sheet patterns NS1 adjacent to each other in the third direction D3. The first width expansion region 150R_ER may be defined between the first lower pattern BP1 and the first sheet pattern NS1. The first width expansion region 150R_ER may extend between the first sheet patterns NS1 adjacent to each other in the third direction D3. The first width expansion region 150R_ER may be defined between the inner gate structures INT_GS1, INT_GS2, and INT_GS3 adjacent to each other in the first direction D1.

As it extends away from the upper surface BP1_US of the first lower pattern BP1, each first width expansion region 150R_ER may include a portion in which the width in the first direction D1 increases, and a portion in which the width in the first direction D1 decreases. For example, as it extends away from the upper surface BP1_US of the first lower pattern BP1 in the third direction D3, the width of the first width expansion region 150R_ER may increase and then decrease in the first direction D1.

In each first width expansion region 150R_ER, a point on which the width of the first width expansion region 150R_ER is maximum is located between the first sheet pattern NS1 and the first lower pattern BP1 adjacent to each other in the third direction D3, and between the first sheet patterns NS1 adjacent to each other in the third direction D3.

Since the description of the first width expansion region 150R_ER may be applied to the second width expansion region 250R_ER, the description of the second width expansion region 250R_ER will not be provided.

The first source/drain pattern 150 may contact the first sheet pattern NS1 and the first lower pattern BP1. Since the first gate spacer 140 is not disposed between the adjacent first sheet patterns NS1 and between the first sheet pattern NS1 and the first lower pattern BP1, the inner gate structures INT1_GS1, INT2_GS1, and INT3_GS1 may contact the first source/drain pattern 150. The first gate insulating film 130 of the inner gate structures INT1_GS1, INT2_GS1, and INT3_GS1 may contact the first source/drain pattern 150.

The second source/drain pattern 250 may contact the second sheet pattern NS2 and the second lower pattern BP2. The inner gate structures INT1_GS2, INT2_GS2, and INT3_GS2 may contact the second source/drain pattern 250. The second gate insulating film 230 of the inner gate structures INT1_GS2, INT2_GS2, and INT3_GS2 may contact the second source/drain pattern 250.

The first source/drain pattern 150 and the second source/drain pattern 250 may include an epitaxial pattern. The first source/drain pattern 150 and the second source/drain pattern 250 include a semiconductor material.

The first source/drain pattern 150 and the second source/drain pattern 250 may include, for example, silicon or germanium, which are elemental semiconductor materials. Further, the first source/drain pattern 150 and the second source/drain pattern 250 may include a binary compound or a ternary compound including at least two or more of carbon (C), silicon (Si), germanium (Ge), and tin (Sn), or a compound obtained by doping these elements with a group IV element. For example, the first source/drain pattern 150 and the second source/drain pattern 250 may include, but are not limited to, silicon, silicon-germanium, silicon carbide, and the like.

The first source/drain pattern 150 and the second source/drain pattern 250 may include impurities doped in the semiconductor material. For example, the first source/drain pattern 150 and the second source/drain pattern 250 include the same conductive type impurities, for example, n-type impurities. The doped impurities may include at least one of phosphorus (P), arsenic (As), antimony (Sb), and bismuth (Bi).

Although the first source/drain pattern 150 and the second source/drain pattern 250 are shown as being a single film, this is only for convenience of explanation, and the embodiment is not limited thereto. Since the first source/drain pattern 150 and the second source/drain pattern 250 are formed in the same fabricating process, the first source/drain pattern 150 and the second source/drain pattern 250 may have the same semiconductor material film structure.

The following description will be given on the basis of a cross-sectional view taken in the first direction D1 in which the first lower pattern BP1 and the second lower pattern BP2 extend.

For example, an upper surface 250US of the second source/drain pattern may have a concave shape. In the semiconductor device according to some embodiments, the upper surface 150US of the first source/drain pattern may have a convex shape.

When a first source/drain contact 180 is formed, the upper surface 150US of the first source/drain pattern having a convex shape may be seen between the side wall of the first source/drain contact 180 and the side wall of the first gate structure GS1. When a second source/drain contact 280 is formed, the upper surface 250US of the second source/drain pattern having a concave shape may be seen between the side wall of the second source/drain contact 280 and the side wall of the second gate structure GS2.

A depth H11 from the upper surface BP1_US of the first lower pattern to the lowermost part of the first source/drain pattern 150 is smaller than a depth H21 from the upper surface BP2_US of the second lower pattern to the lowermost part of the second source/drain pattern 250.

A height H12 from the upper surface BP1_US of the first lower pattern to the lowermost part of the upper surface 150US of the first source/drain pattern is greater than a height H22 from the upper surface BP2_US of the second lower pattern to the lowermost part of the upper surface 250US of the second source/drain pattern.

When the first source/drain contact 180 is formed, the lowermost part of the upper surface 150US of the first source/drain pattern may be a lowest position in the upper surface 150US of the first source/drain pattern in which the first source/drain contact 180 is not formed. When the second source/drain contact 280 is formed, the lowermost part of the upper surface 250US of the second source/drain pattern may be a lowest position in the upper surface 250US of the second source/drain pattern in which the second source/drain contact 280 is not formed.

A height from the lowermost part of the upper surface 150US of the first source/drain pattern to the uppermost part of the upper surface 150US of the first source/drain pattern may be a first height H13. A height from the lowermost part of the upper surface 250US of the second source/drain pattern to the uppermost part of the upper surface 250US of the second source/drain pattern may be a second height H23. For example, the second height H23 on the upper surface 250US of the second source/drain pattern is greater than the first height H13 on the upper surface 150US of the first source/drain pattern. As used herein, the term "height" may refer to a distance in the third direction D3.

The first source/drain pattern 150 will be described as an example. A height (H11+H12+H13) of the first source/drain pattern 150 may be a height from the lowermost part of the first source/drain pattern 150 to the uppermost part of the upper surface 150US of the first source/drain pattern. The height (H11+H12+H13) of the first source/drain pattern 150 is smaller than the height (H21+H22+H23) of the second source/drain pattern 250.

The fourth inner gate structure INT1_GS2 is the uppermost inner gate structure of the second gate structure GS2. In the semiconductor device according to some embodiments, a height H22 from the upper surface BP2_US of the second lower pattern to the lowermost part of the upper surface 250US of the second source/drain pattern may be smaller than the height H24 from the upper surface BP2_US of the second lower pattern to the lower surface of the fourth inner gate structure INT1_GS2.

Unlike the illustrated example, the height H22 from the upper surface BP2_US of the second lower pattern to the lowermost part of the upper surface 250US of the second source/drain pattern may be the same as or greater than the height H24 from the upper surface BP2_US of the second lower pattern to the lower surface of the fourth inner gate structure INT1_GS2.

The first inner gate structure INT1_GS1 is the uppermost inner gate structure of the first gate structure GS1. For example, the height H12 from the upper surface BP1_US of the first lower pattern to the lowermost part of the upper surface 150US of the first source/drain pattern may be greater than the height from the upper surface BP1_US of the first lower pattern to the upper surface of the first inner gate structure INT1_GS1.

A source/drain etching stop film 185 may be disposed on the side wall of the first gate structure GS1 and on the upper surface 150US of the first source/drain pattern. The source/drain etching stop film 185 may be disposed on the side wall of the second gate structure GS2 and on the upper surface 250US of the second source/drain pattern. Although not shown, the source/drain etching stop film 185 may be disposed on the upper surface of the field insulating film 105.

The source/drain etching stop film 185 may include a material having an etching selectivity with respect to the interlayer insulating film 190 to be described later. The source/drain etching stop film 185 may include, for example, at least one of silicon nitride (SiN), silicon oxynitride (SiON), silicon oxycarbonitride (SiOCN), silicon boronitride (SiBN), silicon oxyboronitride (SiOBN), silicon oxycarbide (SiOC), and combinations thereof.

The interlayer insulating film 190 may be disposed on the source/drain etching stop film 185. The interlayer insulating film 190 may be disposed on the first source/drain pattern 150 and the second source/drain pattern 250. The interlayer insulating film 190 does not cover the upper surface of the first gate capping pattern 145 and the upper surface of the second gate capping pattern 245.

The interlayer insulating film 190 may include, for example, at least one of silicon oxide, silicon nitride, silicon oxynitride, and a low dielectric constant material. The low dielectric constant material may include, for example, but is not limited to, at least one of Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ (Tonen SilaZen), FSG (Fluoride Silicate Glass), polyimide nanofoams such as polypropylene oxide, CDO (Carbon Doped silicon Oxide), OSG (Organo Silicate Glass), SiLK, Amorphous Fluorinated Carbon, silica aerogels, silica xerogels, mesoporous silica or combinations thereof.

The first source/drain contact 180 is disposed on the first source/drain pattern 150. The first source/drain contact 180 is connected to the first source/drain pattern 150. The first source/drain contact 180 passes through the interlayer insulating film 190 and the source/drain etching stop film 185, and may be connected to the first source/drain pattern 150.

The second source/drain contact 280 is disposed on the second source/drain pattern 250. The second source/drain contact 280 is connected to the second source/drain pattern 250.

A first metal silicide film 155 may be further disposed between the first source/drain contact 180 and the first source/drain pattern 150. A second metal silicide film 255 may be further disposed between the second source/drain contact 280 and the second source/drain pattern 250.

Although each of the first source/drain contact 180 and the second source/drain contact 280 is shown as being a single film, this is only for convenience of explanation, and the embodiment is not limited thereto. The first source/drain contact 180 and the second source/drain contact 280 may each include, for example, at least one of a metal, a metal alloy, a conductive metal carbonitride, a conductive metal carbide, a conductive metal oxide, a conductive metal carbonitride, and a two-dimensional (2D) material.

The first metal silicide film 155 and the second metal silicide film 255 may include a metal silicide.

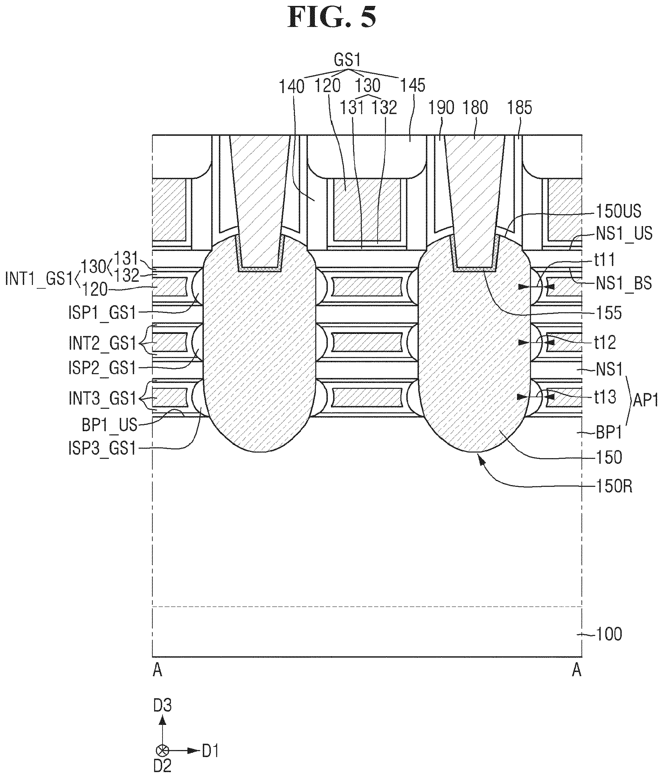

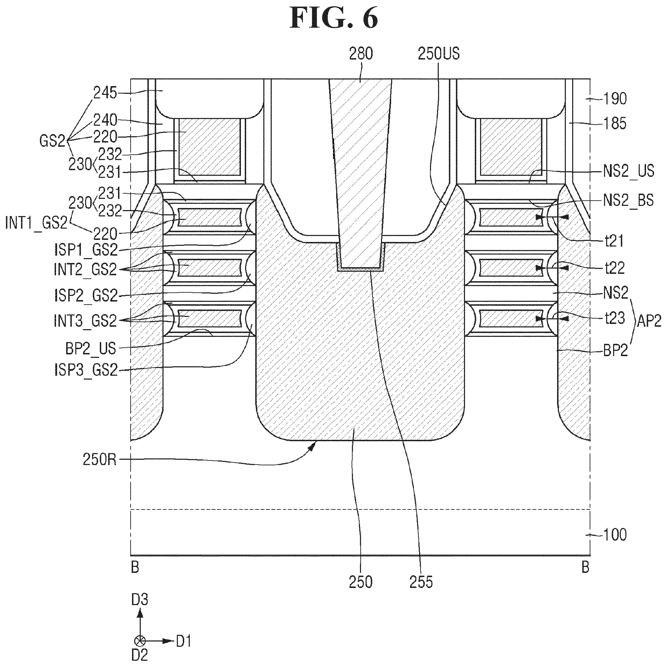

FIGS. 5 and 6 are diagrams for explaining a semiconductor device according to some example embodiments. For convenience of explanation, points different from those described using FIGS. 1 to 4 will be mainly described.

Referring to FIGS. 5 and 6, in a semiconductor device according to some embodiments, the first gate structure GS1 further includes a plurality of first inner spacers ISP1_GS1, ISP2_GS1, and ISP3_GS1. The second gate structure GS2 further includes a plurality of second inner spacers ISP1_GS2, ISP2_GS2, and ISP3_GS2.

The plurality of first inner spacers ISP1_GS1, ISP2_GS1, and ISP3_GS1 may be disposed between the first sheet patterns NS1 adjacent to each other in the third direction D3, and between the first lower pattern BP1 and the first sheet pattern NS1. The first inner spacers ISP1_GS1, ISP2_GS1, and ISP3_GS1 may be disposed between the upper surface BP1_US of the first lower pattern and the lower surface NS1_BS of the first lowermost sheet pattern, and between the upper surface NS1_US and the first sheet pattern and the lower surface NS1_BS of the first sheet pattern that face each other in the third direction D3.

The plurality of first inner spacers ISP1_GS1, ISP2_GS1, and ISP3_GS1 may contact the upper surface BP1_US of the first lower pattern BP1, the upper surface NS1_US of the first sheet pattern NS1, and the lower surface NS1_BS of the first sheet pattern NS1. The plurality of first inner spacers ISP1_GS1, ISP2_GS1, and ISP3_GS1 are disposed between the inner gate structures INT1_GS1, INT2_GS1, and INT3_GS1 and the first source/drain pattern 150. The number of the plurality of first inner spacers ISP1_GS1, ISP2_GS1, and ISP3_GS1 arranged in the third direction D3 is the same as the number of the inner gate structures INT1_GS1, INT2_GS1, and INT3_GS1.

The first gate spacer 140 may include a first sub-inner spacer ISP1_GS1, a second sub-inner spacer ISP2_GS1, and a third sub-inner spacer ISP3_GS1. The first sub-inner spacer ISP1_GS1, the second sub-inner spacer ISP2_GS1, and the third sub-inner spacer ISP3_GS1 may be sequentially disposed on the first lower pattern BP1.

The third sub-inner spacer ISP3_GS1 may be disposed between the first lower pattern BP1 and the first sheet pattern NS1. The third sub-inner spacer ISP3_GS1 may be disposed at the lowermost part of the first inner spacers ISP1_GS1, ISP2_GS1, and ISP3_GS1. The third sub-inner spacer ISP3_GS1 may contact the upper surface BP1_US of the first lower pattern BP1.

The first sub-inner spacer ISP1_GS1 and the second sub-inner spacer ISP2_GS1 may be disposed between the first sheet patterns NS1 adjacent to each other in the third direction D3. The second sub-inner spacer ISP2 GS1 may be disposed between the first sub-inner spacer ISP1_GS1 and the third sub-inner spacer ISP3_GS1.

The first gate interface insulating film 13 1 may not extend along the side walls of the first inner spacers ISP1_GS1, ISP2_GS1, and ISP3_GS1. The first gate high dielectric constant insulating film 132 extends along the side walls of the first inner spacers ISP1_GS1, ISP2_GS1, and ISP3_GS1. However, depending on the method of forming the first gate interface insulating film 131, the first gate interface insulating film 131 may extend along the side walls of the first inner spacers ISP1_GS1, ISP2_GS1, and ISP3_GS1.

Since the first inner spacers ISP1_GS1, ISP2_GS1, and ISP3_GS1 are disposed between the inner gate structures INT1_GS1, INT2_GS1, and INT3_GS1 and the first source/drain pattern 150, respectively, the inner gate structures INT1_GS1, INT2_GS1, and INT3_GS1 do not contact the first source/drain pattern 150.

The side walls of the first source/drain recess 150R may be defined by the first sheet pattern NS1 and the first inner spacers ISP1_GS1, ISP2_GS1, and ISP3_GS1. The first source/drain recess 150R may not include the first width expansion region (e.g., first width expansion region 150R_ER of FIG. 2).

The plurality of second inner spacers ISP1_GS2, ISP2_GS2, and ISP3_GS2 may be disposed between the second sheet patterns NS2 adjacent to each other in the third direction D3, and between the second lower pattern BP2 and the second sheet pattern NS2. The plurality of second inner spacers ISP1_GS2, ISP2_GS2, and ISP3_GS2 may contact the upper surface BP2_US of the second lower pattern BP2, the upper surface NS2_US of the second sheet pattern NS2, and the lower surface NS2_BS of the second sheet pattern NS2.

The plurality of second inner spacers ISP1_GS2, ISP2_GS2, and ISP3_GS2 are disposed between the inner gate structures INT1_GS2, INT2_GS2, and INT3_GS2 and the first source/drain pattern 250. The second gate spacer 240 may include a fourth sub-inner spacer ISP1_GS2, a fifth sub-inner spacer ISP2_GS2, and a sixth sub-inner spacer ISP3_GS2.

The sixth sub-inner spacer ISP3_GS2 may be disposed between the second lower pattern BP2 and the second sheet pattern NS2. The sixth sub-inner spacer ISP3_GS2 may be disposed at the lowermost part of the second inner spacers ISP1_GS2, ISP2_GS2, ISP3_GS2. The fifth sub-inner spacer ISP2_GS2 is disposed between the fourth sub-inner spacer ISP1_GS2 and the sixth sub-inner spacer ISP3_GS2.

The second gate interface insulating film 231 may not extend along the side walls of the second inner spacers ISP1_GS2, ISP2_GS2, and ISP3_GS2. The second gate high dielectric constant insulating film 232 extends along the side walls of the second inner spacers ISP1_GS2, ISP2_GS2, and ISP3_GS2. The inner gate structures INT1_GS2, INT2_GS2, and INT3_GS2 do not contact the second source/drain pattern 250. The side walls of the second source/drain recess 250R may be defined by the second sheet pattern NS2 and the second inner spacers ISP1_GS2, ISP2_GS2, and ISP3_GS2.

The first inner spacers ISP1_GS1, ISP2_GS1, and ISP3_GS1 and the second inner spacers ISP1_GS2, ISP2_GS2, and ISP3_GS2 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof.

In FIG. 5, a thickness t11 of the first sub-inner spacer ISP1_GS1 in the first direction D1 may be the same as a thickness t12 of the second sub-inner spacer ISP2_GS1 in the first direction D1. A thickness t13 of the third sub-inner spacer ISP3_GS1 in the first direction D1 may be the same as the thickness t12 of the second sub-inner spacer ISP2_GS1 in the first direction D1.

The second sub-inner spacer ISP2_GS1 will be described as an example. The thickness t12 of the second sub-inner spacer ISP2_GS1 in the first direction D1 may be measured in the middle between the upper surface NS1_US of the first sheet pattern and the lower surface NS1_BS of the first sheet pattern that face each other in the third direction D3.

In FIG. 6, a thickness t21 of the fourth sub-inner spacer ISP1_GS2 in the first direction D1 may be the same as a thickness t22 of the fifth sub-inner spacer ISP2_GS2 in the first direction D1. A thickness t23 of the sixth sub-inner spacer ISP3_GS2 in the first direction D1 may be the same as the thickness t22 of the fifth sub-inner spacer ISP2 GS2 in the first direction D1.

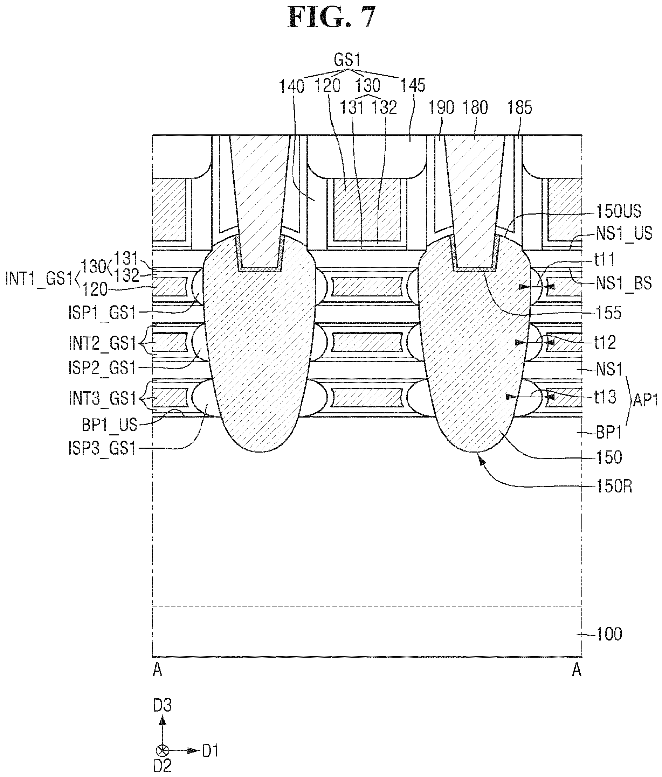

FIG. 7 is a diagram for explaining the semiconductor device according to some example embodiments. For convenience of explanation, the points different from those described using FIGS. 5 and 6 will be mainly described.

Referring to FIG. 7, in the semiconductor device according to some embodiments, the thickness t13 of the third sub-inner spacer ISP3_GS1 in the first direction D1 is greater than the thickness t12 of the second sub-inner spacer ISP2_GS1 in the first direction D1.

The thickness t11 of the first sub-inner spacer ISP1_GS1 in the first direction D1 may be smaller than the thickness t12 of the second sub-inner spacer ISP2_GS1 in the first direction D1.

Unlike that shown, the thickness t11 of the first sub-inner spacer ISP1_GS1 in the first direction D1 may be the same as the thickness t12 of the second sub-inner spacer ISP2_GS1 in the first direction D1.

Although the thicknesses of the first inner spacers ISP1_GS1, ISP2_GS1, and ISP3_GS1 differ depending on the distance from the first lower pattern BP1, the thicknesses of the second inner spacers ISP1_GS2, ISP2_GS2, and ISP3_GS2 may be the same as those described in FIG. 6.

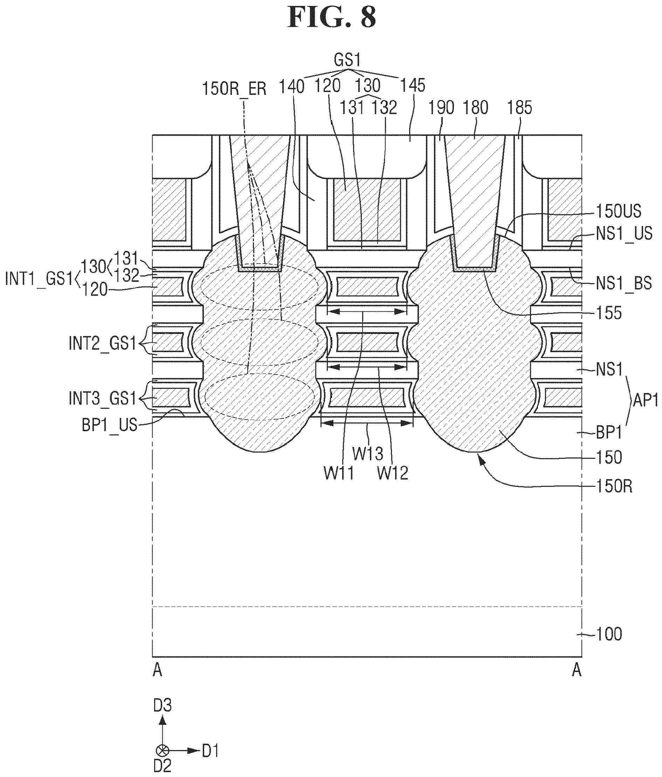

FIG. 8 is a diagram for explaining a semiconductor device according to some example embodiments. For convenience of explanation, the points different from those described using FIGS. 1 to 4 will be mainly described.

Referring to FIG. 8, in the semiconductor device according to some embodiments, a width W13 of the third inner gate structure INT3_GS1 in the first direction D1 may be greater than the width W12 of the second inner gate structure INT2_GS1 in the first direction D1.

Among the inner gate structures INT1_GS1, INT2_GS1, and INT3_GS1 included in the first gate structure GS1, the width W13 of the third inner gate structure INT3_GS1 may be the greatest.

On the other hand, the widths of the inner gate structures INT1_GS2, INT2_GS2, and INT3_GS2 included in the second gate structure GS2 may be the same as those described using FIG. 3.

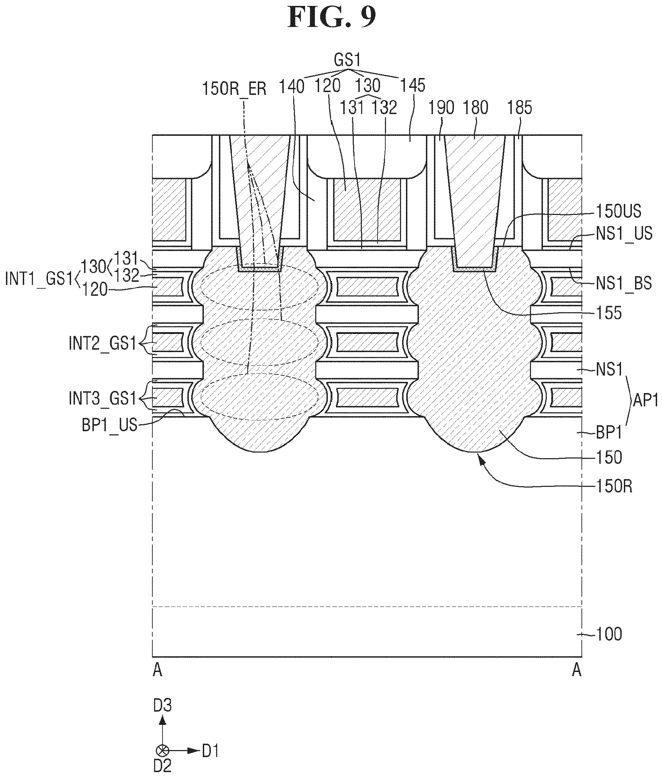

FIGS. 9 to 12 are diagrams for explaining a semiconductor device according to some example embodiments, respectively. For convenience of explanation, the points different from those described using FIGS. 1 to 4 will be mainly described.

Referring to FIG. 9, in a semiconductor device according to some embodiments, an upper surface 150US of the first source/drain pattern may be a flat surface.

On the other hand, an upper surface 250US of the second source/drain pattern may have a concave shape.

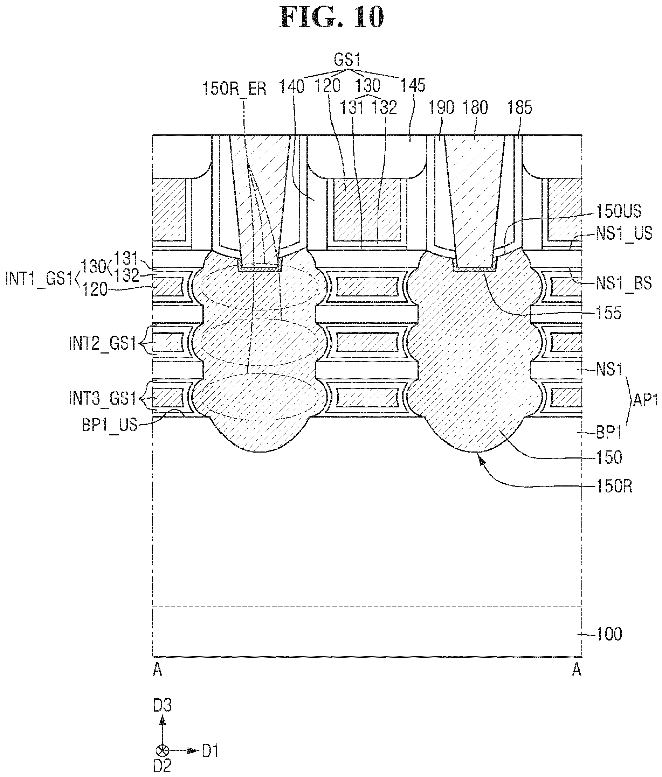

Referring to FIG. 10, in a semiconductor device according to some embodiments, the upper surface 150US of the first source/drain pattern and the upper surface 250US of the second source/drain pattern may each have a concave shape.

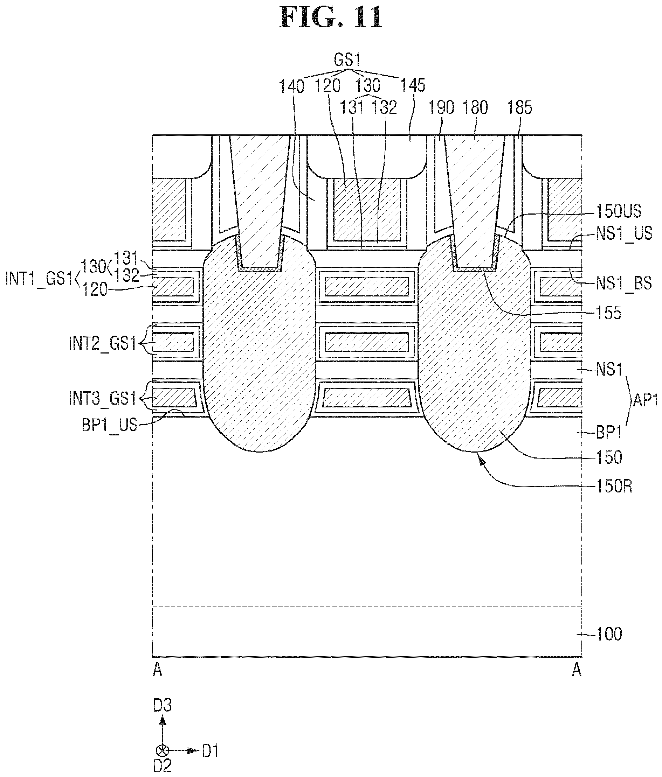

Referring to FIG. 11, in a semiconductor device according to some embodiments, the first source/drain recess 150R does not include the plurality of first width expansion regions (e.g., first width expansion regions 150R_ER of FIG. 2).

The side wall of the first source/drain recess 150R does not have a wavy form. The width of the upper part of the side wall of the first source/drain recess 150R in the first direction D1 may decrease, as it extends away from the first lower pattern BP1.

Although not shown, the second source/drain recess 250R does not include the plurality of second width expansion regions (e.g., second width expansion regions 250R_ER of FIG. 3).

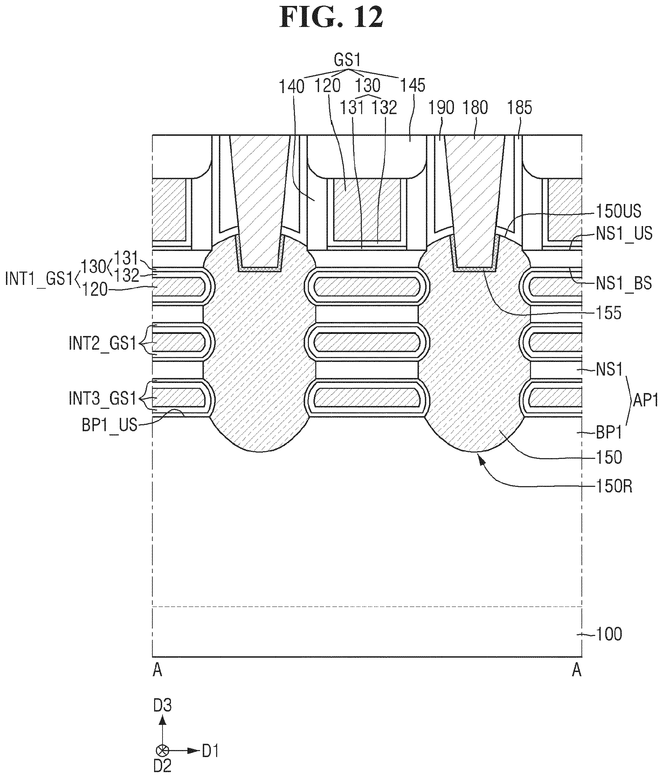

Referring to FIG. 12, in a semiconductor device according to some embodiments, the inner gate structures INT1_GS1, INT2_GS1, and INT3_GS1 may protrude in the first direction D1 toward the first source/drain pattern 150 beyond at least one or more first sheet patterns NS1.

For example, a part of the first inner gate structure INT1_GS1 and a part of the second inner gate structure INT_GS2 may protrude toward the first source/drain pattern 150 beyond the first sheet pattern NS1 between the first inner gate structure INT1_GS1 and the second inner gate structure INT2_GS1.

A part of the second inner gate structure INT2_GS1 and a part of the third inner gate structure INT3_GS1 may protrude toward the first source/drain pattern 150 beyond the first sheet pattern NS1 between the second inner gate structure INT2_GS1 and the third inner gate structure INT3_GS1.

Although not shown, the inner gate structures INT1_GS2, INT2_GS2, and INT3_GS2 may protrude toward the second source/drain pattern 250 in the first direction D1 beyond at least one or more second sheet patterns NS2.

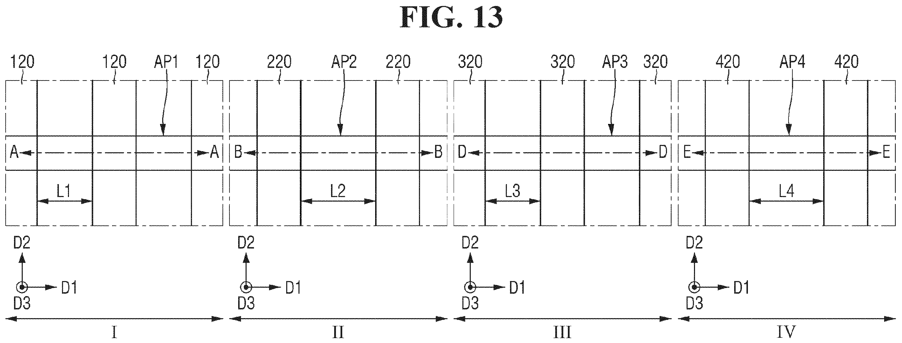

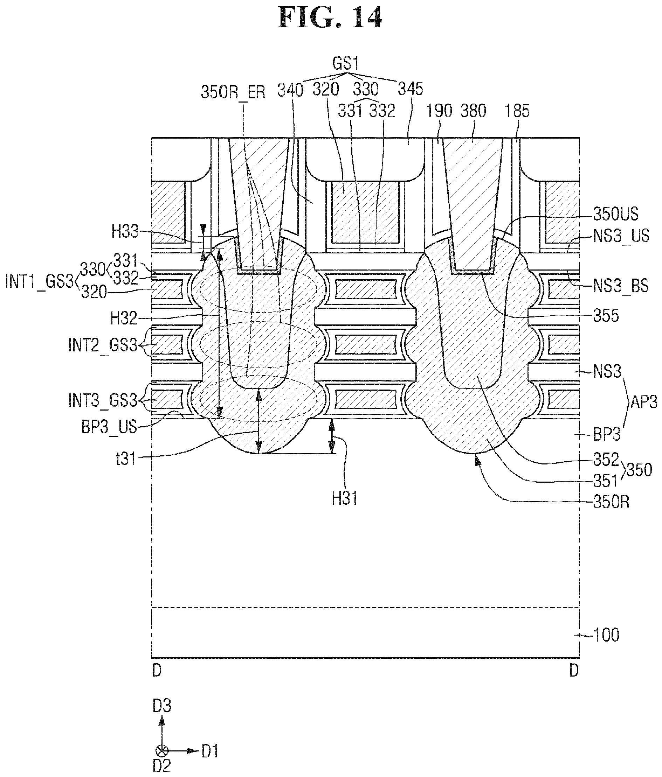

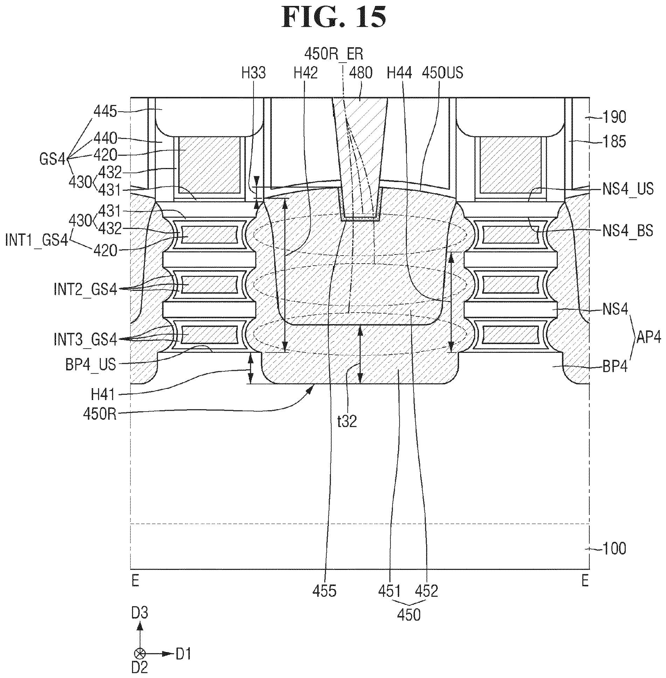

FIG. 13 is an exemplary layout diagram for explaining the semiconductor device according to some example embodiments. FIG. 14 is a cross-sectional view taken along a line D-D of FIG. 13. FIG. 15 is a cross-sectional view taken along a line E-E of FIG. 13.

For reference, the cross-sectional view taken along lines A-A and B-B of FIG. 13 may be the same as one of FIGS. 2, 3, and 5 to 12. The description of the first region I and the second region II of FIG. 13 may be substantially the same as those described using FIGS. 1 to 12. Therefore, the following description will focus on the contents relating to a third region III and a fourth region IV of FIG. 13.

Referring to FIGS. 13 to 15, the semiconductor device according to some embodiments may include a first active pattern AP1, a plurality of first gate electrodes 120, a first source/drain pattern 150, a second active pattern AP2, a plurality of second gate electrodes 220, a second source/drain pattern 250, a third active pattern AP3, a plurality of third gate electrodes 320, a third source/drain pattern 350, a fourth active pattern AP4, a plurality of fourth gate electrodes 420, and a fourth source/drain pattern 450.

The substrate 100 may include a first region I, a second region II, a third region III, and a fourth region IV. The first region I and the second region II may be regions in which NMOS is formed, and the third region III and the fourth region IV may be regions in which PMOS is formed. As an example, the third region III and the fourth region IV may be regions that perform the same function as each other. As another example, the third region III and the fourth region IV may be regions that perform different functions from each other.

The third active pattern AP3 may include a third lower pattern BP3 and a plurality of third sheet patterns NS3. The fourth active pattern AP4 may include a fourth lower pattern BP4 and a plurality of fourth sheet patterns NS4. The third lower pattern BP3 may extend lengthwise in the first direction D1. A plurality of third sheet patterns NS3 may be disposed on the third lower pattern BP3. The fourth lower pattern BP4 may extend lengthwise in the first direction D1. A plurality of fourth sheet patterns NS4 may be disposed on the fourth lower pattern BP4.

Each third sheet pattern NS3 may include an upper surface NS3_US and a lower surface NS3_BS. Each fourth sheet pattern NS4 may include an upper surface NS4_US and a lower surface NS4_BS.

The third lower pattern BP3 and the fourth lower pattern BP4 may include one of silicon or germanium, a group IV-IV compound semiconductor, or a group III-V compound semiconductor, which are elemental semiconductor materials, respectively. The third sheet pattern NS3 and the fourth sheet pattern NS4 may include one of silicon or germanium, a group IV-IV compound semiconductor, or a group III-V compound semiconductor, which are elemental semiconductor materials, respectively.

A plurality of third gate structures GS3 may be disposed on the substrate 100. Each third gate structure GS3 may extend in the second direction D2. The third gate structure GS3 may be disposed apart from each other in the first direction D1. A plurality of fourth gate structures GS4 may be disposed on the substrate 100. Each fourth gate structure GS4 may extend in the second direction D2. The fourth gate structure GS4 may be disposed apart from each other in the first direction D1.

The third gate structure GS3 may include a plurality of inner gate structures INT1_GS3, INT2_GS3, and INT3_GS3 which are disposed between the third sheet patterns NS3 adjacent to each other in the third direction D3, and between the third lower pattern BP3 and the third sheet pattern NS3. The third gate structure GS3 may include a seventh inner gate structure INT1_GS3, an eighth inner gate structure INT2_GS3, and a ninth inner gate structure INT3_GS3. The inner gate structures INT1_GS3, INT2_GS3, and INT3_GS3 may contact the third source/drain pattern 350 to be described later.

The fourth gate structure GS4 may include a plurality of inner gate structures INT1_GS4, INT2_GS4, and INT3_GS4 which are disposed between the fourth sheet patterns NS4 adjacent to each other in the third direction D3, and between the fourth lower pattern BP4 and the fourth sheet pattern NS4. The fourth gate structure GS4 may include a tenth inner gate structure INT1_GS4, an eleventh inner gate structure INT2_GS4, and a twelfth inner gate structure INT3_GS4. The inner gate structures INT1_GS4, INT2_GS4, and INT3_GS4 may contact a fourth source/drain pattern 450 to be described later.

The third gate structure GS3 may include, for example, a third gate electrode 320, a third gate insulating film 330, a third gate spacer 340, and a third gate capping pattern 345. The fourth gate structure GS4 may include, for example, a fourth gate electrode 420, a fourth gate insulating film 430, a fourth gate spacer 440, and a fourth gate capping pattern 445.

The third gate electrode 320 may be disposed on the third lower pattern BP3. The fourth gate electrode 420 may be disposed on the fourth lower pattern BP4. The third gate electrodes 320 adjacent to each other in the first direction D1 may be spaced apart by a third distance L3. The fourth gate electrodes 420 adjacent to each other in the first direction D1 may be spaced apart by a fourth distance L4. The distance L4 by which the fourth gate electrodes 420 are spaced apart is greater than the distance L3 by which the third gate electrodes 320 are spaced apart.

The third gate insulating film 330 may include a third gate interface insulating film 331 and a third gate high dielectric constant insulating film 332. The fourth gate insulating film 430 may include a fourth gate interface insulating film 431 and a fourth gate high dielectric constant insulating film 432.

Other descriptions of the third gate electrode 320, the fourth gate electrode 420, the third gate insulating film 330, the fourth gate insulating film 430, the third gate spacer 340, the fourth gate spacer 440, the third gate capping pattern 345 and the fourth gate capping pattern 445 are substantially the same as the descriptions of the first gate electrode 120, the first gate insulating film 130, the first gate spacer 140, and the first gate capping pattern 145, respectively, and therefore, the descriptions will not be provided below.

The third source/drain pattern 350 may be disposed on the third active pattern AP3. The third source/drain pattern 350 may be disposed on the third lower pattern BP3. The third source/drain pattern 350 is connected to the third sheet pattern NS3.

The fourth source/drain pattern 450 may be disposed on the fourth active pattern AP4. The fourth source/drain pattern 450 may be disposed on the fourth lower pattern BP4. The fourth source/drain pattern 450 is connected to the fourth sheet pattern NS3.

The third source/drain pattern 350 may be disposed in the third source/drain recess 350R. The fourth source/drain pattern 450 may be disposed in the fourth source/drain recess 450R. In the semiconductor device according to some embodiments, the third source/drain recess 350R and the fourth source/drain recess 450R may be formed by different fabricating processes from each other.

A bottom surface of the third source/drain recess 350R may be defined by the third lower pattern BP3. A bottom surface of the fourth source/drain recess 450R may be defined by the fourth lower pattern BP4. The side wall of the third source/drain recess 350R is defined by the third sheet pattern NS3 and the inner gate structures INT1_GS3, INT2_GS3, and INT3_GS3. The side wall of the fourth source/drain recess 450R may be defined by the fourth sheet pattern NS4 and the inner gate structures INT1_GS4, INT2_GS4, and INT3_GS4.

The third source/drain recess 350R may include a plurality of third width expansion regions 350R_ER. The fourth source/drain recess 450R may include a plurality of fourth width expansion regions 450R_ER. The descriptions of the shapes of the third source/drain recess 350R and the fourth source/drain recess 450R may be the same as those of the first source/drain recess 150R and the second source/drain recess 250R, respectively.

Unlike the illustrated example, the side wall of the third source/drain recess 350R and the side wall of the fourth source/drain recess 450R may have shapes that are the same as that of the first source/drain recess 150R shown in FIGS. 11 and 12.

The third source/drain pattern 350 may contact the third sheet pattern NS3, the third lower pattern BP3, and the inner gate structures INT1_GS3, INT2_GS3, and INT3_GS3. The fourth source/drain pattern 450 may contact the fourth sheet pattern NS4, the fourth lower pattern BP4, and the inner gate structures INT1_GS4, INT2_GS4, and INT3_GS4.

The third source/drain pattern 350 may include a first semiconductor liner 351 and a first semiconductor filling film 352. The first semiconductor liner 351 may extend along the bottom surface and side walls of the third source/drain recess 350R. The first semiconductor filling film 352 is disposed on the first semiconductor liner 351.

The fourth source/drain pattern 450 may include a second semiconductor liner 451 and a second semiconductor filling film 452. The second semiconductor liner 451 may extend along the bottom surface and side walls of the fourth source/drain recess 450R. The second semiconductor filling film 452 is disposed on the second semiconductor liner 451.

For example, a thickness t31 in the third direction D3 of the first semiconductor liner 351 at the bottom surface of the third source/drain recess 350R may be the same as or greater than a thickness t32 in the third direction D3 of the second semiconductor liner 451 at the bottom surface of the fourth source/drain recess 450R.

The first semiconductor liner 351, the first semiconductor filling film 352, the second semiconductor liner 451, and the second semiconductor filling film 452 may each include silicon germanium. A germanium fraction in the first semiconductor liner 351 is smaller than a germanium fraction in the first semiconductor filling film 352. The germanium fraction in the second semiconductor liner 451 is smaller than the germanium fraction in the second semiconductor filling film 452.

The third source/drain pattern 350 and the fourth source/drain pattern 450 may include impurities doped in the semiconductor material. For example, the third source/drain pattern 350 and the fourth source/drain pattern 450 may include p-type impurities. Doped impurities may include, but are not limited to, boron (B).

Although the upper surface 350US of the third source/drain pattern and the upper surface 450US of the fourth source/drain pattern are shown to have convex shapes, the embodiment is not limited thereto.

Although a depth H31 from an upper surface BP3_US of the third lower pattern to the lowermost part of the third source/drain pattern 350 may be the same as a depth H41 from an upper surface BP4_US of the fourth lower pattern to the lowermost part of the fourth source/drain pattern 450, the embodiment is not limited thereto. That is, the depth H31 from the upper surface BP3_US of the third lower pattern to the lowermost part of the third source/drain pattern 350 may be smaller or greater than the depth H41 from the upper surface BP4_US of the fourth lower pattern to the lowermost part of the fourth source/drain pattern 450.

A height H32 from the upper surface BP3_US of the third lower pattern to the lowermost part of the upper surface 350US of the third source/drain pattern may be the same as the height H42 from the upper surface BP4_US of the fourth lower pattern to the lowermost part of the upper surface 450US of the fourth source/drain pattern, the embodiment is not limited thereto.

Although a height H33 from the lowermost part of the upper surface 350US of the third source/drain pattern to the uppermost part of the upper surface 350US of the third source/drain pattern may be the same as a height H43 from the lowermost part of the upper surface 450US of the fourth source/drain pattern to the uppermost part of the upper surface 450US of the fourth source/drain pattern, the embodiment is not limited thereto.

The tenth inner gate structure INT1_GS4 is the uppermost inner gate structure of the fourth gate structure GS4. In the semiconductor device according to some embodiments, a height H42 from the upper surface BP4_US of the fourth lower pattern to the lowermost part of the upper surface 450US of the fourth source/drain pattern may be greater than a height H44 from the upper surface BP4_US of the fourth lower pattern to the lower surface of the tenth inner gate structure INT1_GS4. For example, the height H42 from the upper surface BP4_US of the fourth lower pattern to the lowermost part of the upper surface 450US of the fourth source/drain pattern may be greater than the height from the upper surface BP4_US of the fourth lower pattern to the upper surface of the tenth inner gate structure INT1_GS4.

The seventh inner gate structure INT1_GS3 is the uppermost inner gate structure of the third gate structure GS3. For example, the height H32 from the upper surface BP3_US of the third lower pattern to the lowermost part of the upper surface 350US of the third source/drain pattern may be greater than the height from the upper surface BP3_US of the third lower pattern to the upper surface of the seventh inner gate structure INT1GS3.

The third source/drain contact 380 is disposed on the third source/drain pattern 350. The third source/drain contact 380 is connected to the third source/drain pattern 350.

The fourth source/drain contact 480 is disposed on the fourth source/drain pattern 450. The fourth source/drain contact 480 is connected to the fourth source/drain pattern 450.

A third metal silicide film 355 may be further disposed between the third source/drain contact 380 and the third source/drain pattern 350. A fourth metal silicide film 455 may be further disposed between the fourth source/drain contact 480 and the fourth source/drain pattern 450.

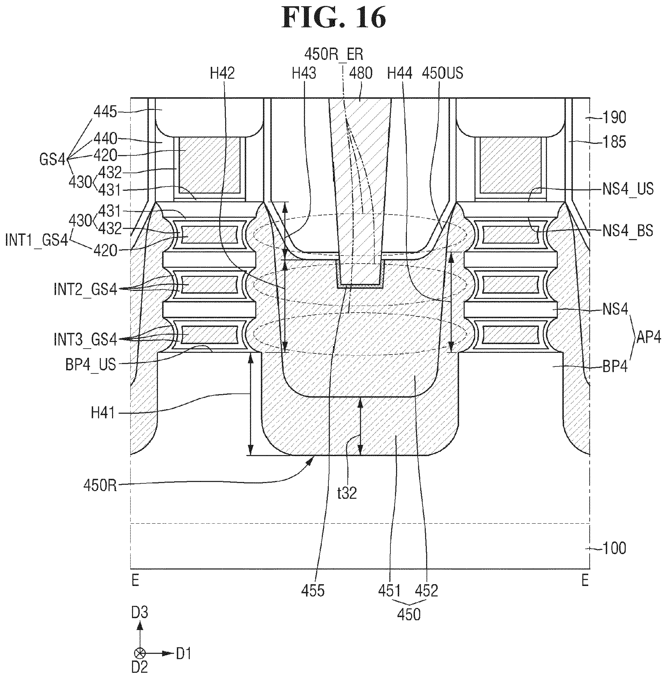

FIG. 16 is a diagram for explaining the semiconductor device according to some example embodiments. For convenience of explanation, the points different from those described using FIGS. 13 to 15 will be mainly described.

Referring to FIG. 16, in a semiconductor device according to some embodiments, the depth H31 from the upper surface BP3_US of the third lower pattern to the lowermost part of the third source/drain pattern 350 is smaller than the depth H41 from the upper surface BP4_US of the fourth lower pattern to the lowermost part of the fourth source/drain pattern 450.

The height H32 from the upper surface BP3_US of the third lower pattern to the lowermost part of the upper surface 350US of the third source/drain pattern is greater than the height H42 from the upper surface BP4_US of the fourth lower pattern to the lowermost part of the upper surface 450US of the fourth source/drain pattern.

The height H33 from the lowermost part of the upper surface 350US of the third source/drain pattern to the uppermost part of the upper surface 350US of the third source/drain pattern is smaller than the height H43 from the lowermost part of the upper surface 450US of the fourth source/drain pattern to the uppermost part of the upper surface 450US of the fourth source/drain pattern.

The height (H31+H32+H33) of the third source/drain pattern 350 is smaller than the height (H41+H42+H43) of the fourth source/drain pattern 450.

The height H42 from the upper surface BP4_US of the fourth lower pattern to the lowermost part of the upper surface 450US of the fourth source/drain pattern may be smaller than the height H44 from the upper surface BP4_US of the fourth lower pattern to the lower surface of the tenth inner gate structure INT1_GS4.

Terms such as "same," "equal," "planar," or "coplanar," as used herein when referring to orientation, layout, location, shapes, sizes, amounts, or other measures, do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

While the inventive concept has been particularly shown and described with reference to embodiments thereof, it will be understood that various changes in form and details may be made therein without departing from the spirit and scope of the following claims.

## Claims

1. A semiconductor device comprising:
a first active pattern which includes a first lower pattern extending lengthwise in a first direction, and a plurality of first sheet patterns spaced apart from the first lower pattern in a second direction;
a plurality of first gate structures which are spaced apart in the first direction on the first lower pattern, each of the plurality of first gate structures including a first gate electrode and a first gate insulating film, the first gate electrodes adjacent to each other in the first direction being spaced apart by a first distance;
a second active pattern which includes a second lower pattern extending lengthwise in the first direction, and a plurality of second sheet patterns spaced apart from the second lower pattern in the second direction;
a plurality of second gate structures which are spaced apart in the first direction on the second lower pattern, each of the plurality of second gate structures including a second gate electrode and a second gate insulating film, the second gate electrodes adjacent to each other in the first direction being spaced apart by a second distance greater than the first distance;
a first source/drain recess defined between the adjacent first gate structures;
a second source/drain recess defined between the adjacent second gate structures;
a first source/drain pattern disposed in the first source/drain recess; and
a second source/drain pattern disposed in the second source/drain recess,
wherein a depth from an upper surface of the first lower pattern to a lowermost part of the first source/drain pattern is smaller than a depth from an upper surface of the second lower pattern to a lowermost part of the second source/drain pattern, and
wherein the first source/drain pattern and the second source/drain pattern include impurities of same conductive type.

2. The semiconductor device of claim 1,
wherein each of the plurality of first gate structures includes an inner gate structure which is disposed between the first lower pattern and the first sheet pattern, and between the adjacent first sheet patterns, the inner gate structure includes the first gate electrode and the first gate insulating film, and
wherein the first source/drain pattern contacts the first gate insulating film of the inner gate structure.

3. The semiconductor device of claim 1, wherein the first gate structure includes a plurality of inner spacers disposed between the first lower pattern and the first sheet pattern, and between the adjacent first sheet patterns.

4. The semiconductor device of claim 1,
wherein each of the plurality of second gate structures includes a first inner gate structure disposed between the second lower pattern and the second sheet pattern, and a second inner gate structure disposed between the adjacent second sheet pattern, and
wherein a width of the first inner gate structure in the first direction is the same as a width of the second inner gate structure in the first direction.

5. The semiconductor device of claim 4,
wherein each of the plurality of first gate structures includes a third inner gate structure disposed between the first lower pattern and the first sheet pattern, and a fourth inner gate structure disposed between the adjacent first sheet patterns, and
wherein a width of the third inner gate structure in the first direction is the same as a width of the fourth inner gate structure in the first direction.

6. The semiconductor device of claim 1,
wherein an upper surface of the first source/drain pattern has a convex shape, and
wherein an upper surface of the second source/drain pattern has a concave shape.

7. The semiconductor device of claim 1,
wherein the upper surface of the first source/drain pattern is a flat surface, and
wherein the upper surface of the second source/drain pattern has a concave shape.

8. The semiconductor device of claim 1, wherein the upper surface of the first source/drain pattern and the upper surface of the second source/drain pattern each have a concave shape.

9. A semiconductor device comprising:
a first active pattern which includes a first lower pattern extending lengthwise in a first direction, and a plurality of first sheet patterns spaced apart from the first lower pattern in a second direction;
a plurality of first gate structures which are spaced apart in the first direction on the first lower pattern, each of the plurality of first gate structures including a first gate electrode and a first gate insulating film, the first gate electrodes adjacent to each other in the first direction being spaced apart by a first distance;
a second active pattern which includes a second lower pattern extending lengthwise in the first direction, and a plurality of second sheet patterns spaced apart from the second lower pattern in the second direction;
a plurality of second gate structures which are spaced apart in the first direction on the second lower pattern, each of the plurality of second gate structures including a second gate electrode and a second gate insulating film, the second gate electrodes adjacent to each other in the first direction being spaced apart by a second distance greater than the first distance;
a first source/drain recess defined between the adjacent first gate structures;
a second source/drain recess defined between the adjacent second gate structures;
a first source/drain pattern disposed in the first source/drain recess; and
a second source/drain pattern disposed in the second source/drain recess,
wherein a height from an upper surface of the first lower pattern to a lowermost part of an upper surface of the first source/drain pattern is greater than a height from an upper surface of the second lower pattern to a lowermost part of an upper surface of the second source/drain pattern, and
wherein the first source/drain pattern and the second source/drain pattern each include n-type impurities.

10. The semiconductor device of claim 9, wherein a height of the first source/drain pattern is smaller than a height of the second source/drain pattern.

11. The semiconductor device of claim 9, wherein a depth from the upper surface of the first lower pattern to the lowermost part of the first source/drain pattern is smaller than a depth from the upper surface of the second lower pattern to the lowermost part of the second source/drain pattern.

12. The semiconductor device of claim 9,
wherein each of the plurality of first gate structures includes an inner gate structure which is disposed between the first lower pattern and the first sheet pattern, and between the adjacent first sheet patterns, the inner gate structure includes the first gate electrode and the first gate insulating film, and
wherein the first source/drain pattern contacts the first gate insulating film of the inner gate structure.

13. The semiconductor device of claim 9, wherein each of the plurality of first gate structures includes a plurality of inner spacers which are disposed between the first lower pattern and the first sheet pattern, and between the adjacent first sheet patterns.

14. The semiconductor device of claim 9,
wherein each of the plurality of second gate structures includes a plurality of inner gate structures which are disposed between the second lower pattern and the second sheet pattern, and between the adjacent second sheet patterns,
wherein the plurality of inner gate structures include an uppermost inner gate structure which is farthest from the second lower pattern, and
wherein a height from the upper surface of the second lower pattern to a lowermost part of the upper surface of the second source/drain pattern is smaller than a height from the upper surface of the second lower pattern to the lower surface of the uppermost inner gate structure.

15. A semiconductor device comprising:
a first active pattern which includes a first lower pattern extending lengthwise in a first direction, and a plurality of first sheet patterns spaced apart from the first lower pattern in a second direction;
a plurality of first gate structures which are spaced apart in the first direction on the first lower pattern, each of the plurality of first gate structures including a first gate electrode and a first gate insulating film, the first gate electrodes adjacent to each other in the first direction being spaced apart by a first distance;
a second active pattern which includes a second lower pattern extending lengthwise in the first direction, and a plurality of second sheet patterns spaced apart from the second lower pattern in the second direction;
a plurality of second gate structures which are spaced apart in the first direction on the second lower pattern, each of the plurality of second gate structures including a second gate electrode and a second gate insulating film, the second gate electrodes adjacent to each other in the first direction being spaced apart by a second distance greater than the first distance;
a first source/drain recess defined between the adjacent first gate structures;
a second source/drain recess defined between the adjacent second gate structures;
a first source/drain pattern disposed in the first source/drain recess; and
a second source/drain pattern disposed in the second source/drain recess,
wherein a height from a lowermost part of an upper surface of the first source/drain pattern to an uppermost part of an upper surface of the first source/drain pattern is a first height, and
wherein a height from a lowermost part of an upper surface of the second source/drain pattern to an uppermost part of an upper surface of the second source/drain pattern is a second height greater than the first height.
